# EUROPEAN PATENT SPECIFICATION

(11) **EP 0 836 105 B1**
(45) Date of publication and mention of the grant of the patent: **25.11.2009**
(21) Application number: 97308056.7
(22) Date of filing: 10.10.1997
(51) Int. Cl.: G02B 6/42, H04B 10/24, G11B 7/12, H01L 31/00

(54) **An optical transmission/reception module**
Ein optisches Sende-/Empfangsmodul
Un module optique pour transmission/réception

(30) Priority: 11.10.1996 JP 27021696; 24.06.1997 JP 16701097
(43) Date of publication of application: 15.04.1998
(73) Proprietor: Sharp Kabushiki Kaisha, Abeno-ku Osaka-shi Osaka (JP)
(72) Inventor: Ishihara, Takehisa, Yamatokoriyama-shi, Nara (JP); Kawamura, Masahiro, Nara-shi, Nara (JP)
(74) Representative: Suckling, Andrew Michael

(56) References cited:
- EP-A- 0 654 689
- EP-A- 0 664 585
- DE-A- 4 411 380
- DE-U- 9 319 378
- US-A- 4 279 465
- US-A- 4 297 653
- J.D.CROW: "Integral source/receiver package for optical data" IBM TECHNICAL DISCLOSURE BULLETIN, vol. 20, no. 5, October 1977, pages 2089-2090, XP002051579

## Description

### BACKGROUND OF THE INVENTION

### (1) Field of the Invention

The present invention relates to an optical transmission/reception module for use in an optical communication system in which two-way communication is implemented through a single common optical fiber.

### (2) Description of the Prior Art

Devices for optical communications have been developed up to now with increase in capacity of trunk systems and development into long-distances thereof. At present, to expand optical subscriber systems, various kinds of transmission systems and optical devices associated with them have been studied and developed. However, in order to promote development of the subscriber side optical systems, price reduction of the optical devices has been a big problem.

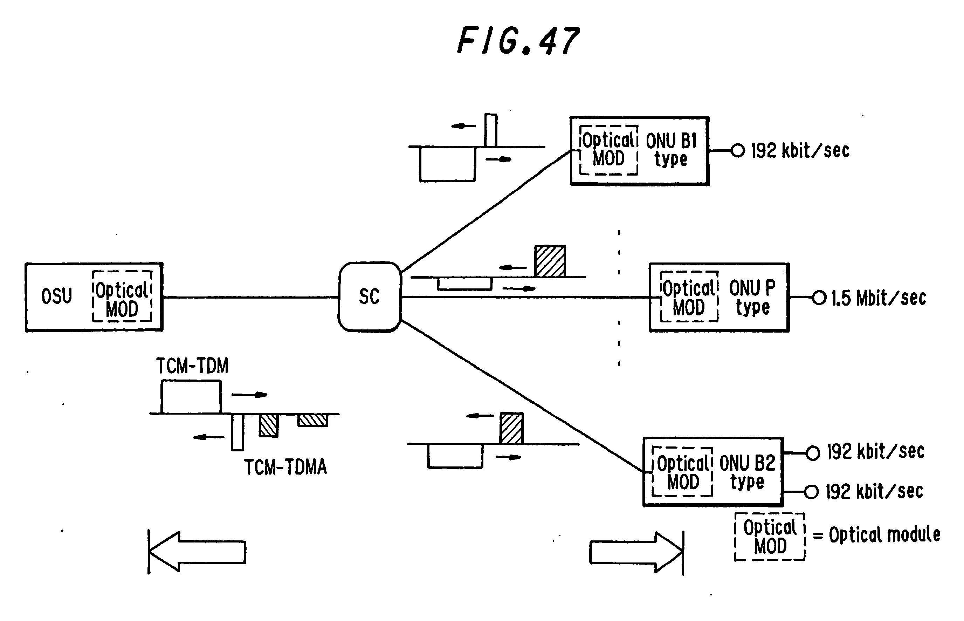

In this respect, NTT proposed a PDS (passive double star) system, which has a one-to-multiple form of communication between a station-side unit (OSU: optical subscriber unit) and a number of subscriber terminals (ONU: optical network unit) by using optical star couplers (SCs), which are passive devices for combining and branching light signals, to thereby improve its reliability and which further uses a single optical fiber for both transmission and reception (two-way communication) to enable construction of an economical system. Fig.47 shows a configurational example of this system, in which a plurality of ONUs are connected to a single OSU via a SC (cf. HP design Symposium '95 p13-1 to 12-22).

The PDS system employs TCM (time compression multiple) which allows a single fiber to perform two-way communications. In the OSU, the signal to each ONU is in the form of TDM (time division multiple) and this is further converted into a TCM burst light signal. The converted light signal is sent out as a down signal from the OSU and is branched to each ONU through a SC. The signal transmitted from each of ONUs to the OSU is converted into a TCM-TDMA (time division multiple access) light signal which is allotted to a set of time intervals that differs from the other and is transmitted as a up signal to the OSU via the SC and the fiber.

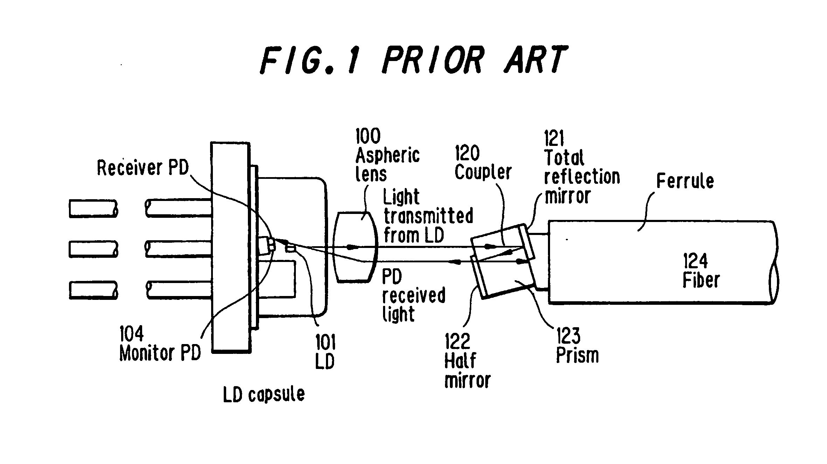

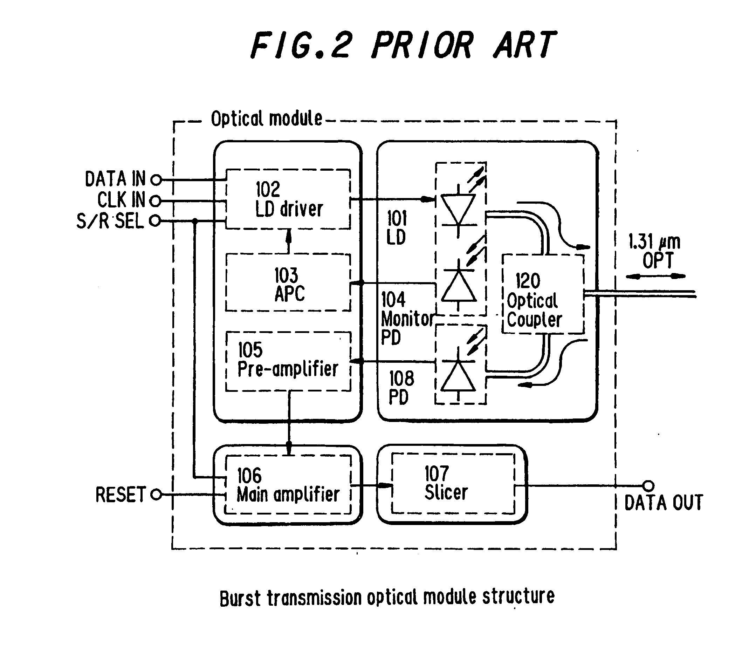

The converting section for converting electrical signals to optical signals and vice versa in the OSU and that in the ONUs are the same, employing the same type of optical transmission/reception modules. A conventional example of such a transmission/reception module has been disclosed in the Fujitsu technical report (FUJITSU 46,5,(09,1995)), which has an optical arrangement as shown in Fig.1 and a module configuration as shown in Fig.2. This will be referred to hereinbelow as conventional example 1.

This optical transmitter portion is composed of a laser diode (LD) 101 having a wavelength of 1.31 µm, a laser diode driver (LD driver) 102 and an automatic optical output power controller (APC) 103. APC 103 detects the level of current (which is proportional to the light output power of laser diode 101) through a monitor diode 104 and controls the LD driver so as to make the light output power of laser diode 101 constant. The light receiver portion is composed of a photodiode (PD) 108, a pre-amplifier 105, a main amplifier 106 and slicer 107. The received light signal is converted by the photodiode into current, which in turn is converted into a voltage by pre-amplifier 105. Further, the pre-amplifier output is further amplified in main amplifier 106, it is then converted into a digital signal in slicer 107.

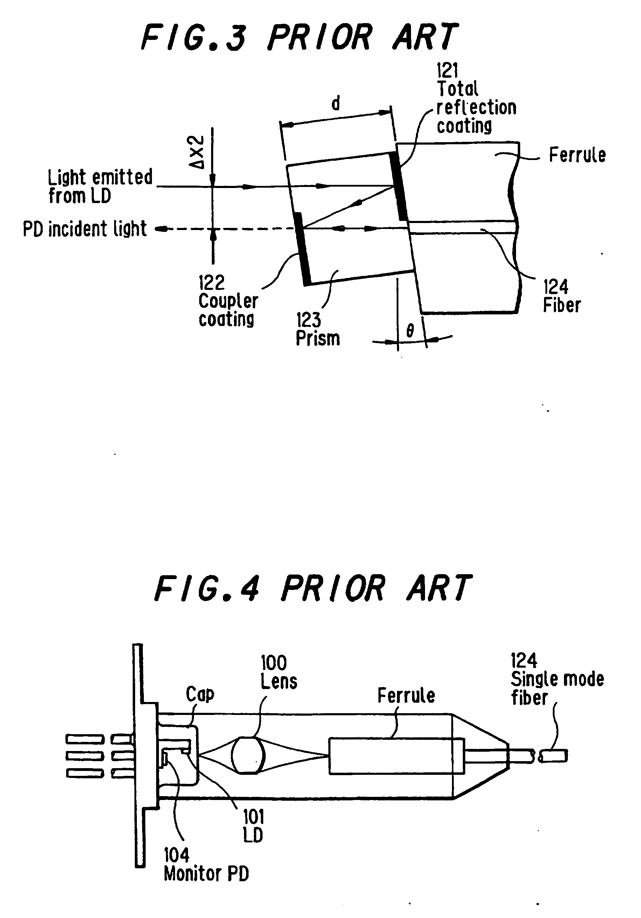

Fig.3 shows a structure of a coupler 120 which functions as an optical branching element. This micro coupler function of the optical branching element is achieved by gluing a miniature glass prism 123 (1.2 x 1.2 mm) with a total reflection coating 121 and coupler coating 122 deposited thereon to an angled end face of a fiber. Half or 50 % of the light beam impinging from a fiber 124 onto prism 123 transmits through coupler film 122 and enter photodiode 108 (photodiode incident light). The light beam which impinges on coupler 120 from laser diode 101 (light emitted from laser diode) is reflected on total reflection coating 121, further 50 % of it being reflected on coupler coating 122 and entering fiber 124.

Another conventional example is disclosed in Japanese Patent Application Laid-Open Hei 1 No. 147,931. This disclosure proposes that a monitor photodiode 104 in a typical laser module (transmission module) shown in Fig.4 is used as the photodiode for reception during the periods of reception of the time division two-way communication so as to eliminate the necessity of the optical coupler having the function of an optical branching element and the photodiode for reception, thus reducing the size and cost. This configuration will be referred to hereinbelow as conventional example 2.

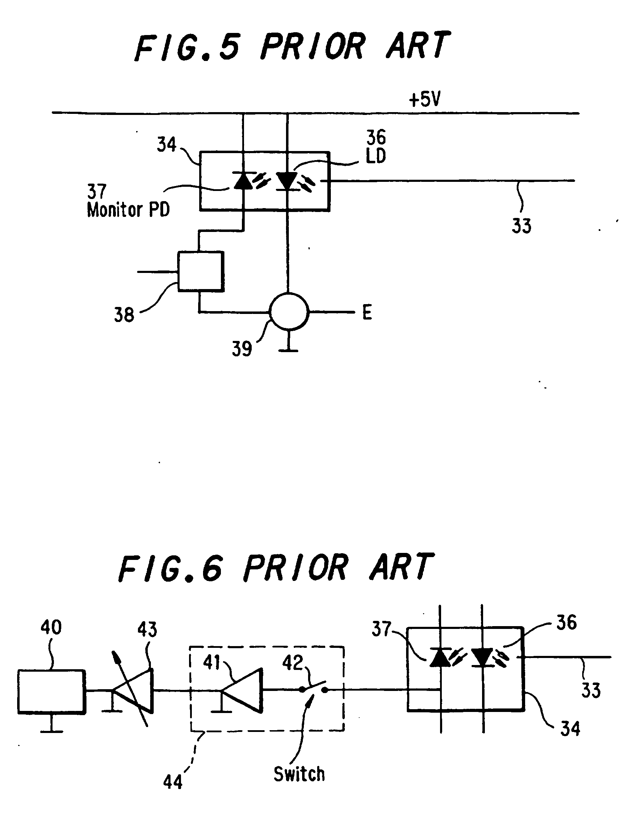

Optical arrangements shown in Figs.5 and 6 are the same as the conventional laser module, but the received light signal from an optical fiber 33 passes through laser diode 36, impinging on a monitor photodiode 37. Since monitor photodiode 37 is used as the photodiode for reception during the periods of reception, a switch 42 is provided in order to connect or disconnect it with an APC 43 and reception circuit 40 in accordance with the timing of transmission and reception.

As still another conventional example, it is disclosed in Japanese Patent Application Laid-Open Hei 6 No. 260,676, that a transmission type photoreceptor element (transmittance controlling type photoreceptor element or transmission type photodiode) is used in place of an optical coupler having the function of an optical branching element, thus reducing the size and cost. This configuration will be referred to hereinbelow as conventional example 3.

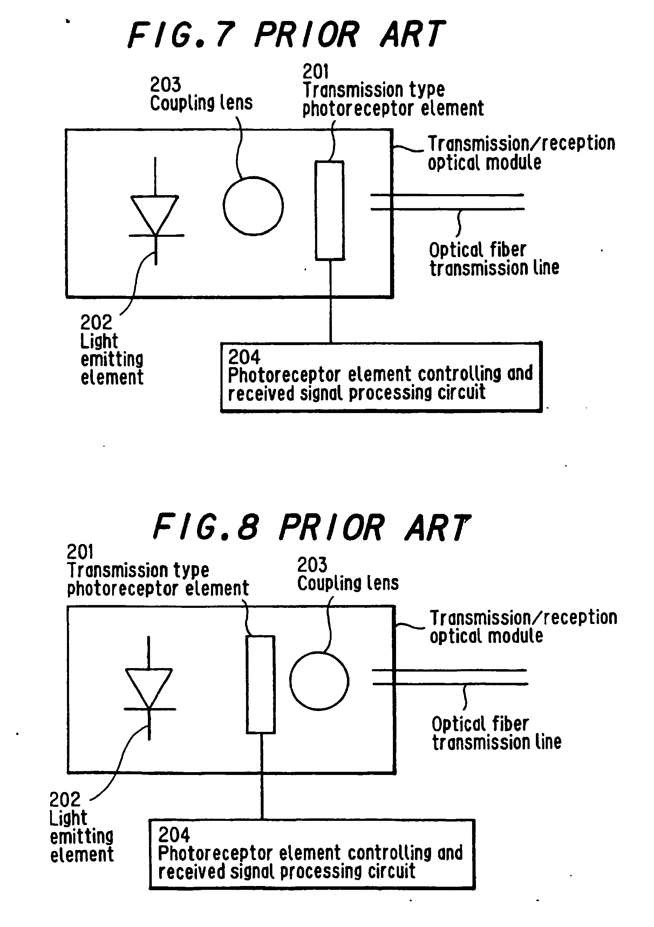

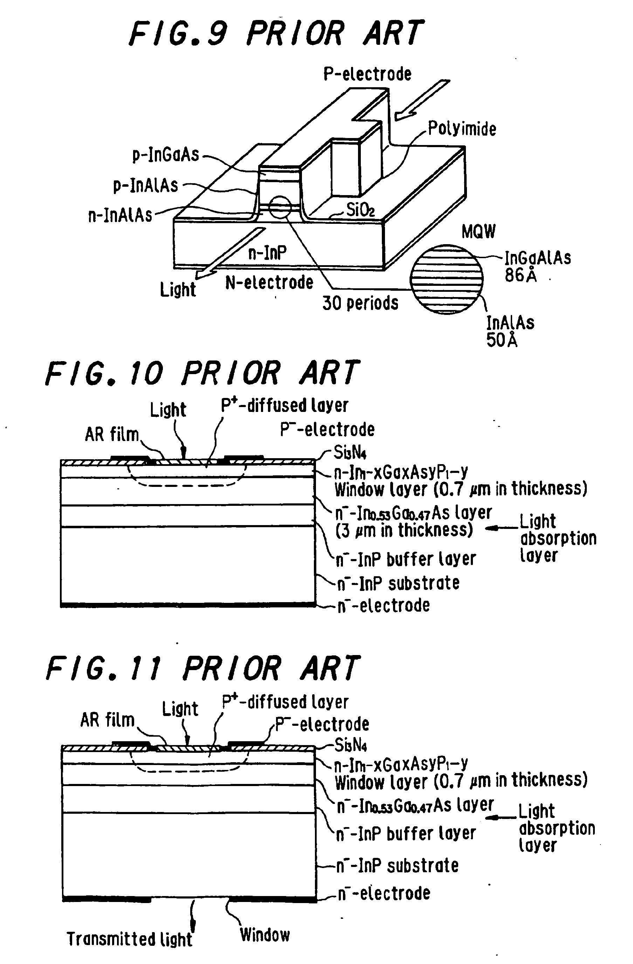

Figs.7 and 8 show examples of optical arrangements where light emitting and receiving portions in an optical communication device are formed in a module. In the example shown in Fig.7, a transmission type photoreceptor element 201 and a light emitting element 202 are integrated with a coupling lens 203 in between. In the example shown in Fig.8, a transmission type photoreceptor element 201 and a light emitting element 202 are arranged to one side of a coupling lens 203 and integrated with this coupling lens 203. Here, in these figures, 204 designates a photoreceptor element controlling and received signal processing circuit. Fig.9 shows an example of the structure of a transmittance controlling type photoreceptor element. This has the same structure as an optical modulator and is made to function as a photoreceptor element by modifying the bias conditions. This element becomes transparent when the applied voltage is 0 V, and will function as a photoreceptor element when the applied voltage is -8 V. Therefore, when the laser diode is modulated with 0 V applied to this transmittance controlling type photoreceptor element during the periods of transmission, no optical loss occurs from the transmittance controlling type photoreceptor element. During the periods of reception, -8 V is applied to the transmittance controlling type photoreceptor element so that it functions as the photoreceptor element, enabling detection of received light signals. It is also possible to modulate the laser diode beam by means of the transmittance controlling type photoreceptor element during the periods of transmittance.

Fig.11 shows a structure of a transmission type photodiode, which has the same structure of the conventional photodiode shown in Fig.10, except in that a window for allowing light to pass therethrough is formed on the electrode disposed on the surface opposite that on which light impinges, and the light absorption layer is made thinner so as to allow transmission of light. The transmittance is controllable by the thickness of the light absorption layer. For example, when the light transmittance is set at 50 % in the optical structure shown in Fig.7 or 8, the light emitted from the laser diode is transmitted 50 % through this photodiode, entering the optical fiber. On the other hand, 50 % of the received light signal from the optical fiber is absorbed by this photodiode thus enabling detection of the received light signal.

Now, description will be made of a conventional example (JIII Journal of Technical Disclosure 94-16,475) relating to an optical pickup for use in an optical disc driver, since the geometry of the components is analogous to that of the invention though it belongs to a different technical field. This configuration will be referred to hereinbelow as conventional example 4.

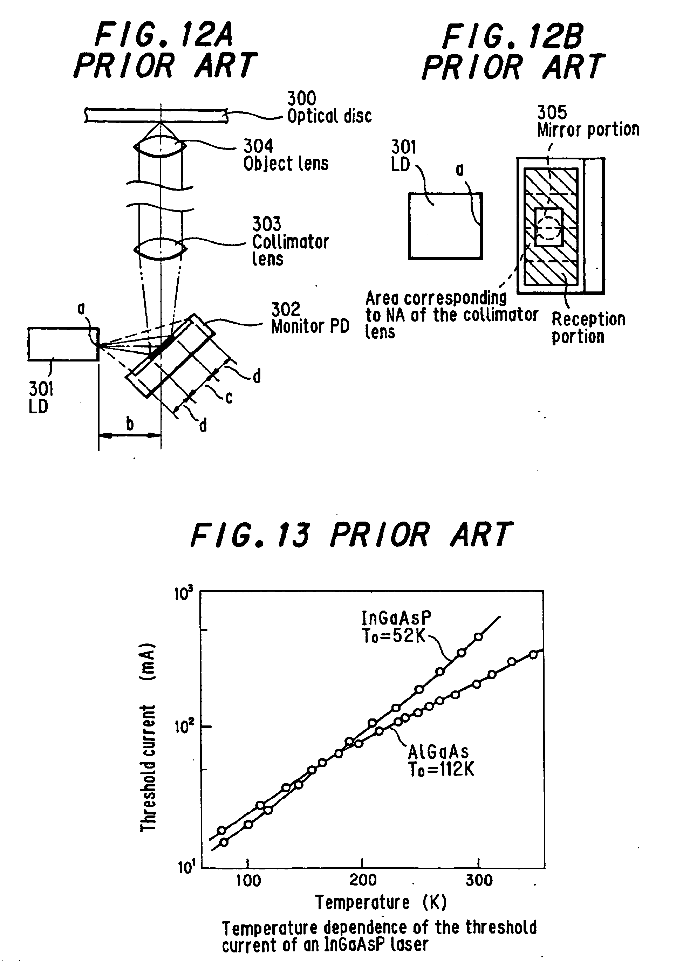

As shown in Fig.12A, this structure has a laser diode LD 301, a monitor photodiode 302 which is inclined with respect to the optical axis, a collimator lens 303, an object lens 304, arranged in this sequential order. Designated at 300 is an optical disc. Fig.12B shows the surface of monitor photodiode 302. The light beams, within the NA (numerical aperture) of the lens, emitted from laser diode 301 are reflected by a mirror portion having a width 'c' formed on the surface of monitor photodiode 302, which is located a distance 'b' away from the laser emitting portion 'a', thus illuminating the optical disc through object lens 304. On the other hand, the beams beyond the NA of the lens, enter the interior of monitor photodiode 302 having an effective width 'd' (other than mirror portion 305) and are used to detect the light output power of laser diode 301. Because, the light beams beyond the NA of the lens, which were conventionally uselessly discarded are made use of, it is possible to enhance the efficiency of light usage. This configuration can omit the individual mirror and hence become less expensive.

However, conventional example 1 suffers from the following problems because a miniature glass prism is used. That is, since the prism is produced by grinding glass, a very long time is required for its fabrication and hence the cost increases. Further, since both sides of the prism have to be coated, this needs more steps, costing more. Since the prism is glued to the slantly abraded end face of the fiber, mass production of this structure is inferior.

In conventional example 2, since the optical configuration is such that the received light signal passes through the laser diode interior during the periods of reception, the following problems occur. First, because it absorbs most of light unless current is made to flow, the laser diode will not allow light to pass therethrough.

For the purpose of solving this problem, in order to use the laser diode as an optical amplifier during the periods of reception, an operational current lower than its threshold current needs to be made to flow through the laser diode. However, since the threshold current of a laser diode varies exponentially in accordance with change in temperature as shown in Fig.13 (see Optical Fiber Transmission, published by Denshitushin Gakkai, p.184), if the level of the operational current flowing through the laser diode is fixed with respect to the temperature, the operational current might exceed the level of the threshold current causing unwanted laser oscillation when the ambient temperature varies. This oscillated laser light masks the received light signal causing difficulty in detecting it; conversely, the current may become insufficient to effect optical amplification, stopping the received light to pass through the diode.

For this reason, the current through the laser diode must be controlled in accordance with the temperature, this needing a temperature detector and a complicated control circuit.

In order to increase the communication speed, the photoreceptor diameter in the photodiode must be made small enough. On the other hand, the received light signal transmitting through the laser diode will spread due to diffraction when it goes out from the laser diode. Therefore, in order for the monitor photodiode to collect a sufficient amount of light, it is necessary and only possible to place the monitor photodiode more closely to the laser diode or provide an extra lens, causing difficulty in assembly.

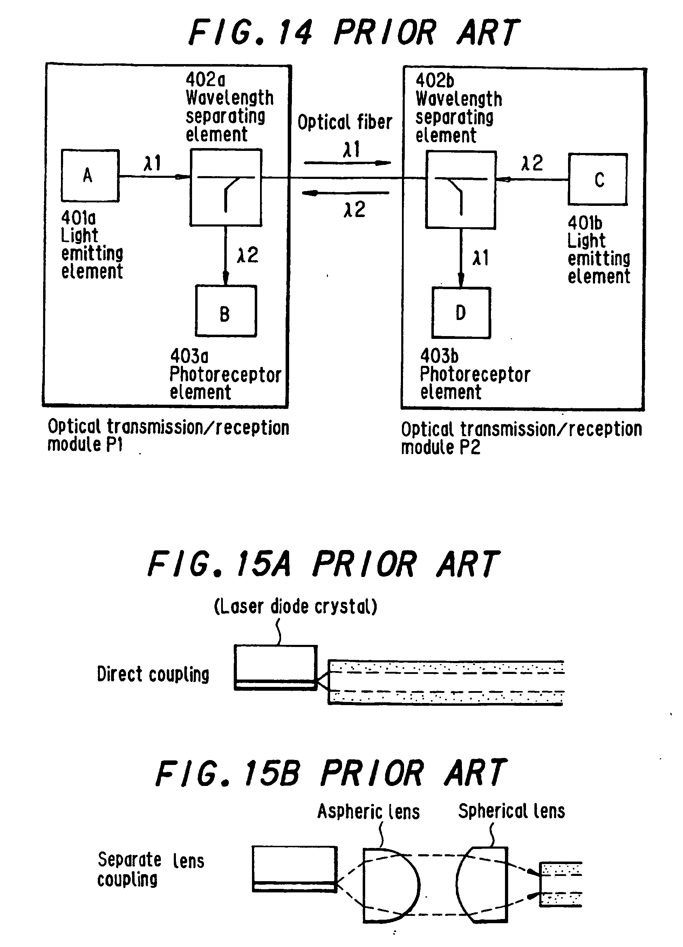

Fig.14 is a configurational example of an optical transmission/reception module for use in wavelength division two-way communication. In this figure, λ1 designates the wavelength of the light from a light emitting element 401a of an optical transmission/reception module P1, λ2 the wavelength of the light from a light emitting element 401b of an optical transmission/reception module P2, and 403a and 403b designate photoreceptor elements. In this configuration, wavelength separating elements 402a and 402b are adapted to separate the wavelength for transmission and that for reception, implementing optical transmission and reception. Therefore, it is impossible to use an optical configuration in which the received light signal passes through the laser diode interior.

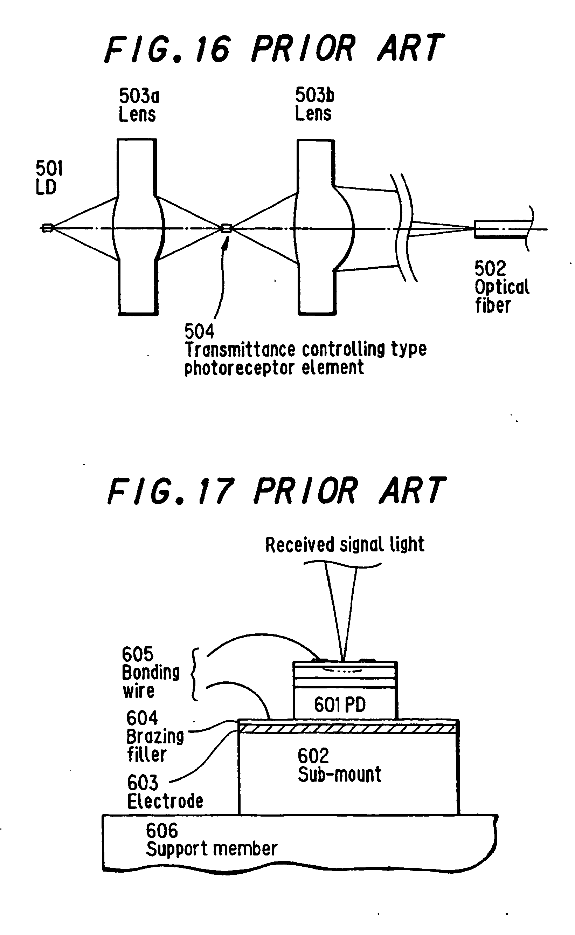

Next, the optical configuration of conventional example 3 using a transmission type photoreceptor element, suffers from the following problems. Since the transmittance controlling type element has a waveguide structure similar to a laser diode, it is difficult to achieve optical coupling. For example, in a direct coupling shown in Fig.15A (cf. Hikari Tushin Soshi Kougaku (Engineering on optical communication element), published by Kogaku Tosho Co., p.266), in order to enhance the coupling efficiency, the transmittance controlling type element must be provided close to the optical fiber element, which causes difficulty in assembly. (As an example, if the diameter of the single core of the optical fiber and NA are assumed to be 10 µm and 0.1, respectively, the distance has to be set at 50 µm or below). Further, when a lens coupling shown in Fig.15B (cf. the above literature) is created, it is necessary to provide an optical configuration as shown in Fig.16, in which a transmittance controlling element 504 is placed between lenses 503a and 503b which correspond to a laser diode 501 and an optical fiber 502, respectively, thus needing an additional lens which is expensive.

In recent years, the applied voltage to ICs has tended to become lower (for example, 3 V for operation). However, the width of the operating bias voltage of the transmission control type element is high, i.e., 8 V, needing an extra power source.

Fig.17 shows a sectional view showing the state of a photodiode 601 mounted on a sub-mount 602. In general, reception photodiode 601 is mounted on a sub-mount 602 made of ceramic or silicon having certain electrical characteristics (insulation, high-frequency characteristic) with an electrode 603 (e.g. gold) formed (by sputtering or other methods) on the top surface thereof, so as to electrically connect the undersurface of photodiode 601 to electrode 603 using a brazing filler metal 604 (e.g. gold-tin). Further, the photodiode is electrically connected to the reception amplifier circuit (IC etc.) by bonding wire 605. As a result, the optical configuration using the transmission type photodiode of conventional example 3 suffers from the following problems.

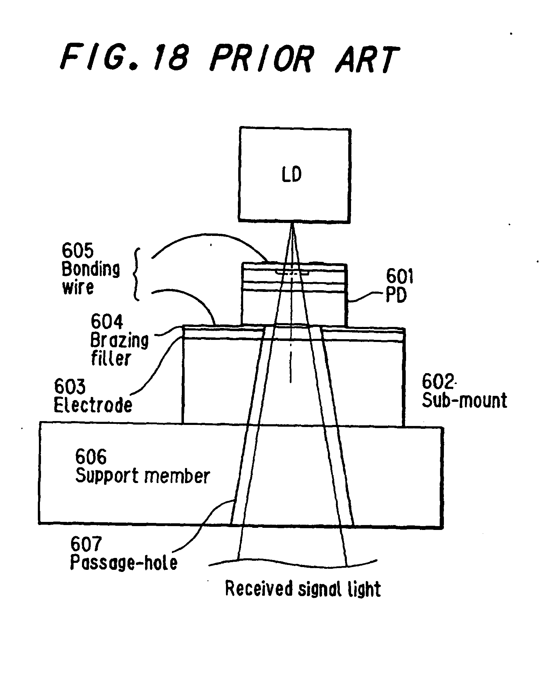

First, because a large amount of light is lost through brazing filler metal 604, sub-mount 602 and a support member 606, photodiode 601 needs to be mounted with a passage-hole 607 formed as shown in Fig.18. This needs additional production steps and therefore cost-saving is reduced. Further, alignment relative to passage-hole 607 is needed, making the mounting work difficult.

Because of the provision of the window on the underside of photodiode 601, the contact area with brazing filler metal 604 decreases. As a result, the strength of adherence decreases, thus degrading the reliability. If photodiode 601 is increased in its size for the purpose of solving this problem, the number of PDs diced from one wafer decreases, and therefore cost-saving is reduced. Further, either of the transmission type photoreceptor elements cannot be used for the wavelength division two-way combination shown in Fig.14.

Further, when the optical pickup of conventional example 4 is applied to the optical communication module, the following problem occurs. That is, the received signal light from the optical fibre is all reflected by the mirror portion of the monitor photodiode, therefore the received signal light cannot be detected by the monitor photodiode.

US-A-4 297 635 discloses an optical transmission/reception module according to the preamble of claim 1.

A metallic reflector is disposed centrally on the inclined surface of the photoreceptor element. The reception area of the photoreceptor element is a substantially annular region that surrounds the metallic reflector.

DE-A-4 411 380 discloses an optical transmission/reception module having a photoreceptor element having a surface that is inclined with respect to the optical axis of light from a light-emitting element. The entire surface of the photoreceptor element is covered with a dielectric film, so that the entire surface is partially reflective and partially transmissive.

The present invention provides an optical transmission/reception module for use in performing two-way communication by way of an optical fibre, the module comprising: a light-emitting element for emitting signal light; and a photoreceptor element which is disposed inclined with respect to the optical axis of signal light from the optical fibre and has an optical branching element formed on a surface thereof, the surface, in use, partially reflecting signal light from the light emitting element and signal light from the optical fibre and allowing the remaining part of the signal light to pass therethrough; wherein, in use, the signal light from the light-emitting element is reflected on the optical branching element on the surface of the photoreceptor element and is optically coupled with the optical fibre; and wherein, in use, signal light from the optical fibre passes through the optical branching element and enters the photoreceptor element; characterised in that the optical branching element comprises a reflection film disposed over a part of the surface of the photoreceptor element, the reflection film, in use, reflecting part of a light beam incident on the surface of the photoreceptor element; in that a part of the surface of the photoreceptor element over which the reflection film is not disposed defines a reception area of the photoreceptor element, the reception area of the photoreceptor element having a shape which can receive the remaining part of the incident light beam; and in that the reception area of the photoreceptor element is formed on a side of the surface of the photoreceptor element where light arrives later, compared to the arrival of light at another side of the surface, when a converging light beam from the optical fibre is incident on the surface and where light arrives earlier, compared to the arrival of light at another side of the surface, when a diverging light beam from the light-emitting element is incident on the surface.

In accordance with the optical transmission/reception module of the present invention, the module uses a photoreceptor element having an optical branching element formed on the surface thereof, without the necessity to provide separate parts such as a coupler having a function of an optical branching element, so that the module can be easily assembled and be made compact.

According to the invention, a reflection film for reflecting part of the incident light is formed on the surface of the photoreceptor element, and the reception area in the photoreceptor element is formed in such a shape which can receive the other part of the incident light. As a result, part of the light that impinges on the photoreceptor element is reflected and the remaining part of the light passes into the interior of the photoreceptor element, thus achieving the function of optical branching.

In the optical transmission/reception module of the invention, the reception area in the photoreceptor element is formed on a side of the surface of the photoreceptor element where light arrives later, compared to the arrival of light at another side of the surface, when a converging light beam from the optical fibre is incident on the surface and where light arrives earlier, compared to the arrival of light at another side of the surface, when a diverging light beam from the light-emitting element is incident on the surface. This configuration enables reduction in size of the reception area, and hence reduces the capacitance of the photoreceptor element, thus improving the speed of response.

In a preferred embodiment of the invention the reception area of the photoreceptor element has a semi-elliptic shape corresponding to the beam shape. The reception area can thus be minimised in size and the speed of response is increased.

In a preferred embodiment an end of each lead of a stem having the light-emitting element and the photoreceptor element mounted thereon is formed approximately parallel to the surface of the corresponding element to which the lead is to be joined by a bonding wire. Therefore, only one rotation of the stem can advantageously achieve adjustment for connecting each piece of bonding wire. Further, since the stem does not need to be rotated for adjustment whilst only one end of the bonding wire is being connected and hence the risk that unwanted stress will be exerted on the bonding wire becomes lower, the wire, beneficially, will not disconnect or break.

### BRIEF DESCRIPTION OF THE DRAWINGS

Fig.1 is an optical arrangement diagram showing a conventional example of an optical transmission/reception module;
Fig.2 is a block diagram showing a conventional example of an optical transmission/reception module;
Fig.3 is a structural diagram showing an optical coupler in an optical transmission/reception module of a conventional example;
Fig.4 is a sectional view showing a pigtail type optical transmission module of a conventional example;
Fig.5 is an optical arrangement diagram showing a conventional example of an optical transmission/reception module;
Fig.6 is a block diagram showing a conventional example of an optical transmission/reception module;
Fig.7 is an optical arrangement diagram showing a conventional example of an optical transmission/reception module;
Fig.8 is an optical arrangement diagram showing a conventional example of an optical transmission/reception module;
Fig.9 is a structural diagram showing a transmittance controlling type photoreceptor element of a conventional example;
Fig.10 is a diagram showing a structure of a conventional photoreceptor;
Fig.11 is a diagram of a structure of a conventional transmission type photoreceptor element;
Figs.12A and 12B are diagrams showing a conventional optical pickup device, Fig.12A is an arrangement diagram and Fig.12B is an illustration showing the surface of a monitor photodiode;
Fig.13 is a chart showing the temperature dependence of the threshold level of the current flowing through a laser diode;
Fig.14 is block diagram showing wavelength-division two-way communication;
Figs.15A and 15B are diagrams showing optical coupling, Fig.15A is a diagram showing a direct coupling and Fig.15B is a diagram showing a lens coupling;
Fig.16 is a configurational diagram showing an optical coupling;
Fig.17 is a structural diagram showing the mounted state of a photoreceptor;
Fig.18 is a structural diagram showing the mounted state of a photoreceptor;
Figs.19A and 19B are diagrams showing a first optical transmission/reception module , Fig.19A is a sectional structural view and Fig.19B is a side view;
Fig.20 is an enlarged sectional view showing a tin capsule;
Fig.21 is an enlarged view showing a receptacle;
Figs.22A-22C are schematic views showing a tin capsule, Fig.22A is a top view, Fig.22B is a side view and Fig.22C is a bottom view;
Fig.23A, 23B and 23C are schematic views showing a tin capsule with its cap removed,

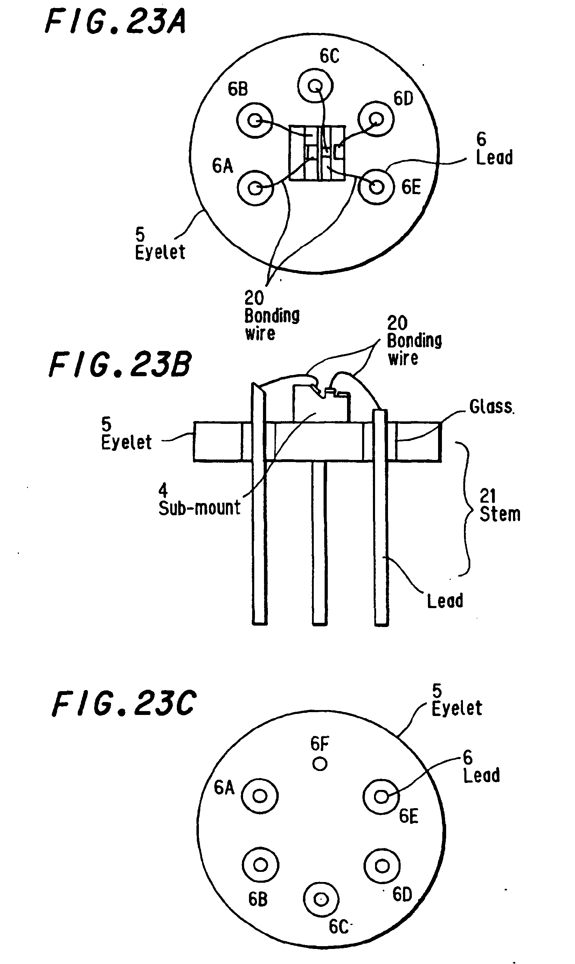

   Fig.23A is a top view, Fig.23B is a side view and Fig.23C is a bottom view;

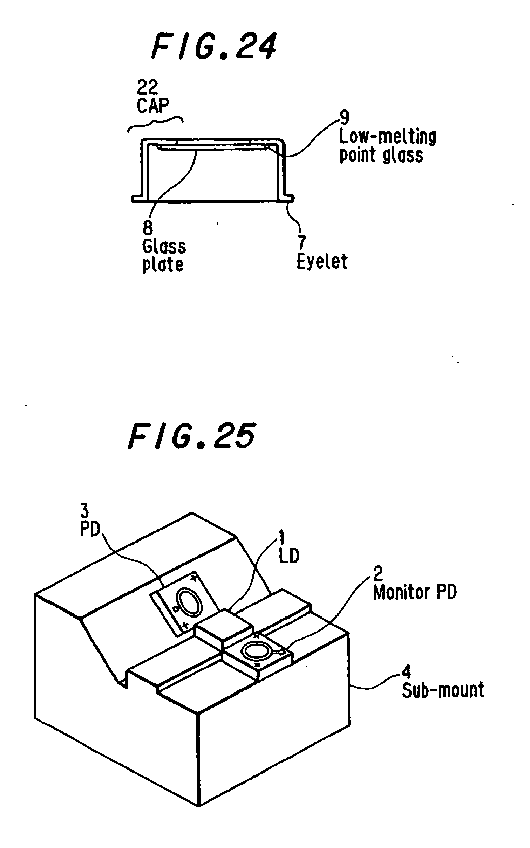

Fig.24 is a sectional view showing a cap of a tin capsule;
Fig.25 is a perspective view showing a sub-mount;

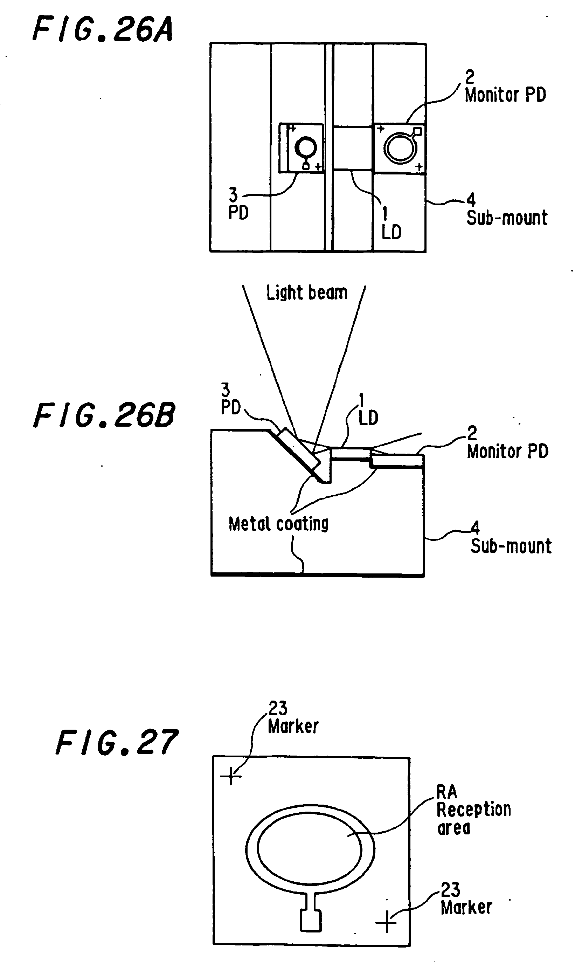

Figs.26A and 26B are diagrams showing a sub-mount, Fig.26A is a top view and Fig.26B is a side view;
Fig.27 is a top view of a photodiode;

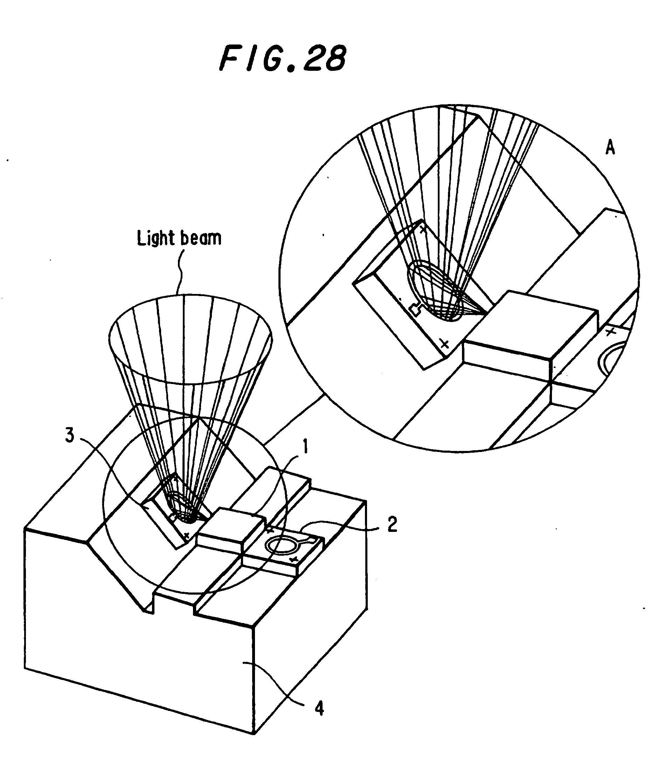

Fig.28 is a perspective view showing how the light beam is reflected upward by an optical branching element on a photodiode;

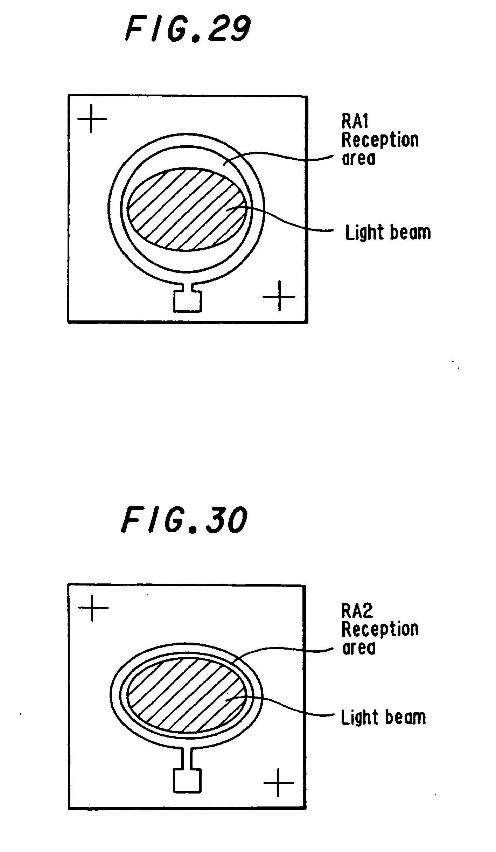

Fig.29 is a top view showing a photoreceptor element having a circular reception area;
Fig.30 is a top view showing a photoreceptor element having an elliptic reception area;

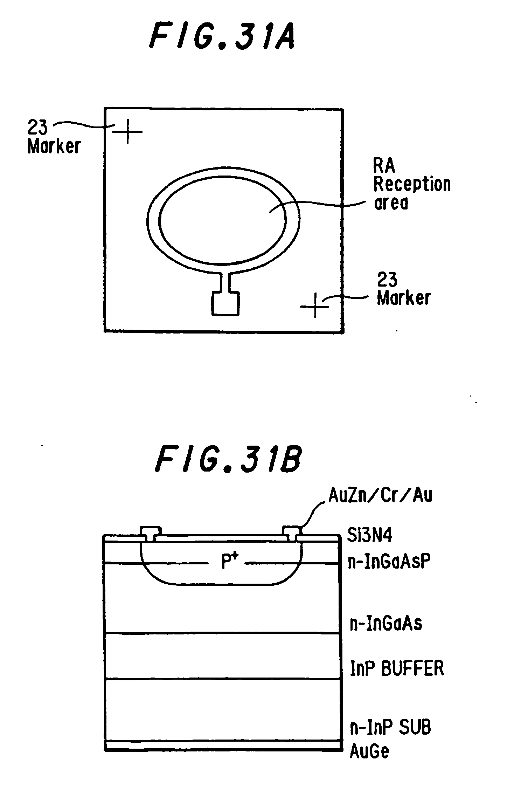

Figs.31A and 31B are diagrams showing an example of a structure of a photodiode, Fig.31A is a top view and Fig.31B is a sectional view;

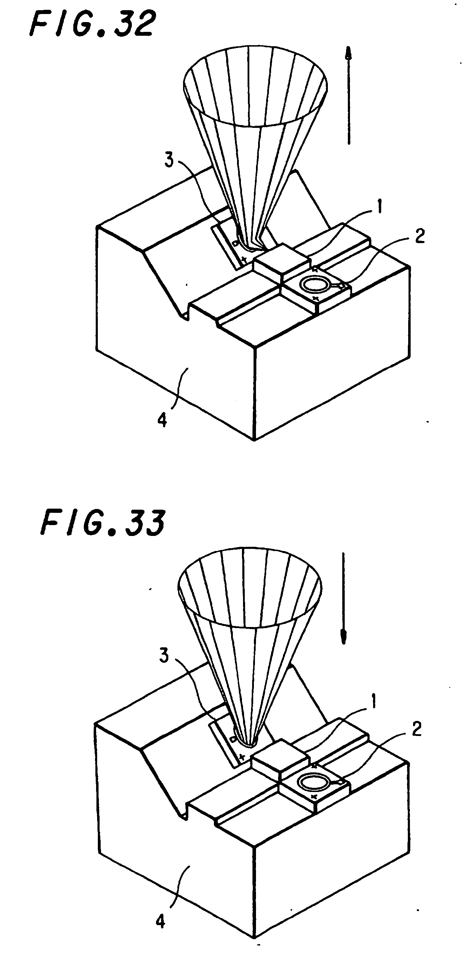

Fig.32 is a perspective view showing how the transmission signal light goes out from the sub-mount;
Fig.33 is a perspective view showing how the received signal light impinges on the sub-mount;

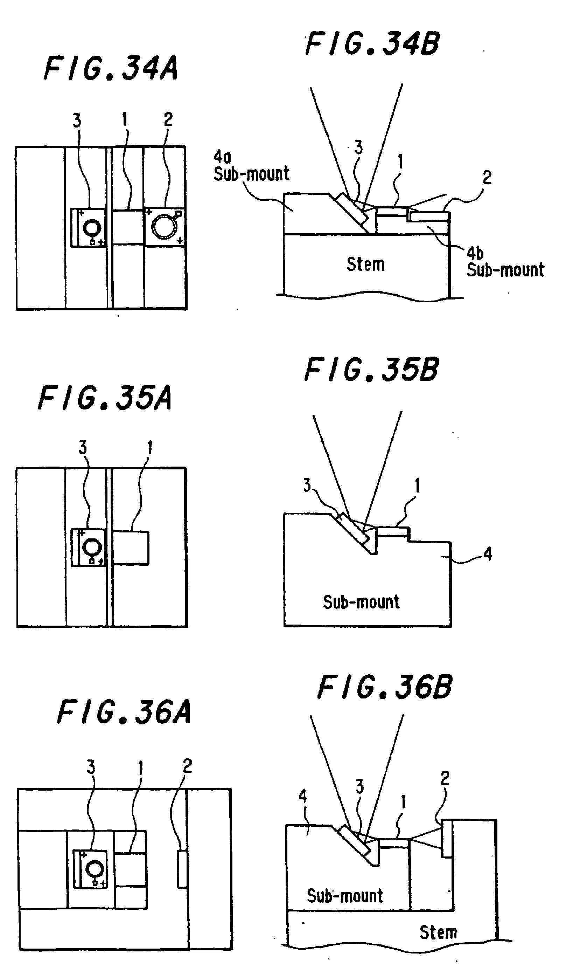

Figs.34A and 34B are diagrams showing another example of a sub-mount, Fig.34A is a top view and Fig.34B is a side view;
Figs.35A and 35B are diagrams showing a further example of a sub-mount, Fig.35A is a top view and Fig.35B is a side view;
Figs.36A and 36B are diagrams showing still another example of a sub-mount, Fig.36A is a top view and Fig.36B is a side view;

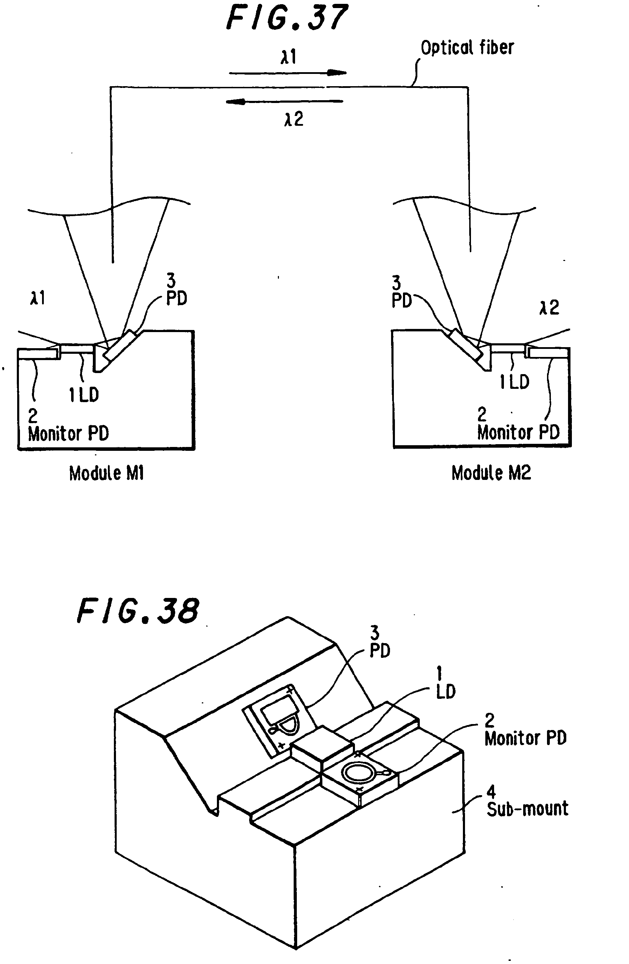

Fig.37 is a diagram for explaining a second optical transmission/reception module;
Fig.38 is a perspective view of a sub-mount;

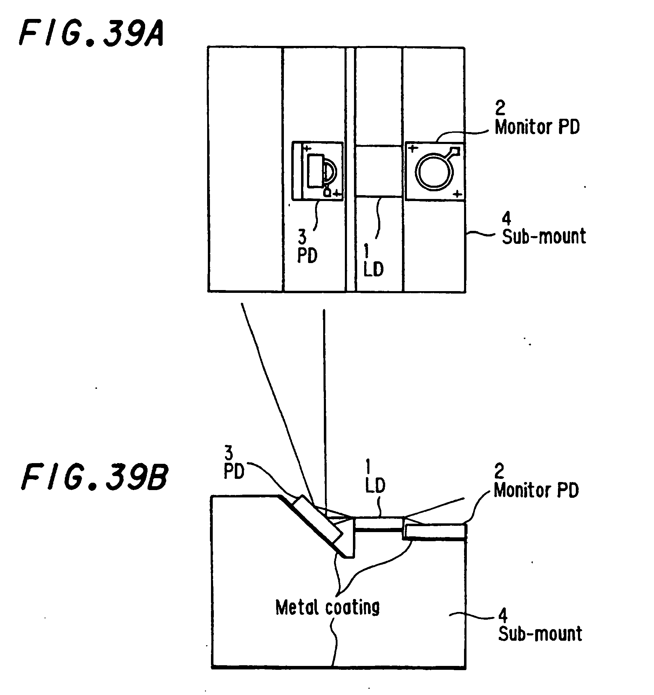

Figs.39A and 39B are diagrams showing a sub-mount of a transmission/reception module in accordance with an embodiment of the invention, Fig.39A is a top view and Fig.39B is a side view;

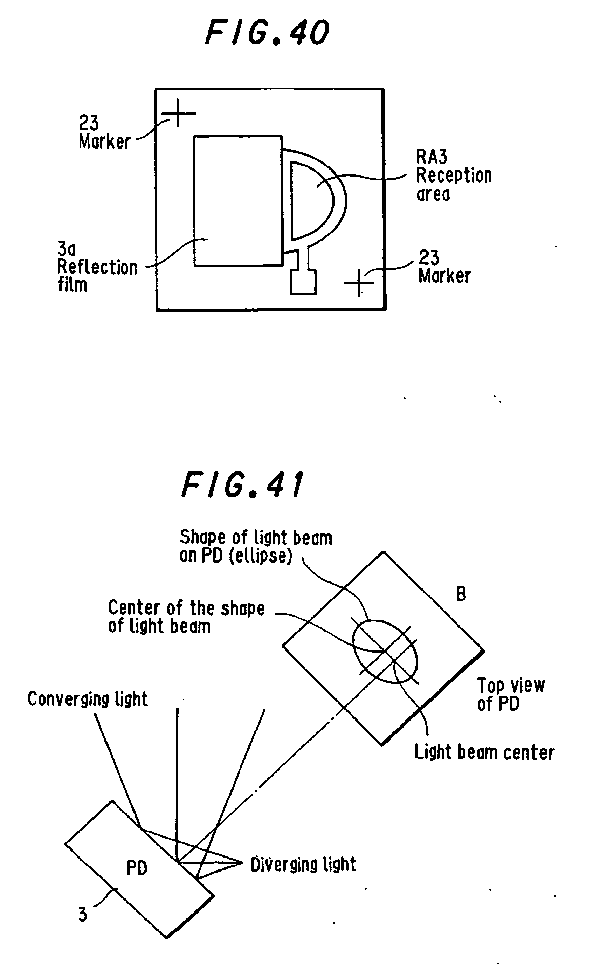

Fig.40 is a top view of a photodiode;
Fig.41 is a diagram showing the shape of the light beam on a photodiode;

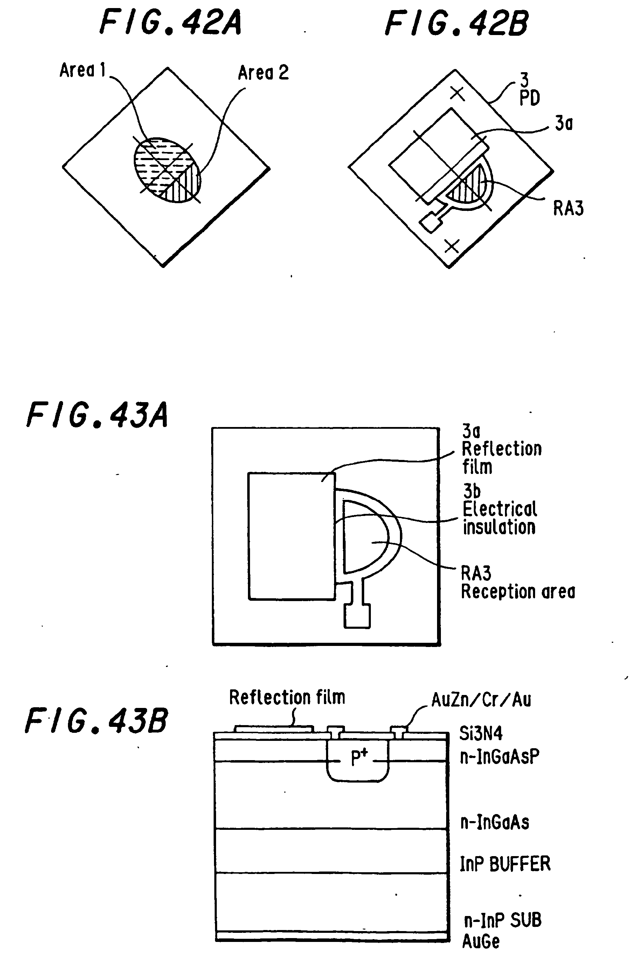

Fig.42A is a diagram showing the shape of the light beam on a photodiode, and Fig.42B is a top view of a photodiode;
Figs.43A and 43B are diagrams showing an example of a structure of a photodiode, Fig.43A is a top view and Fig.43B is a sectional view;

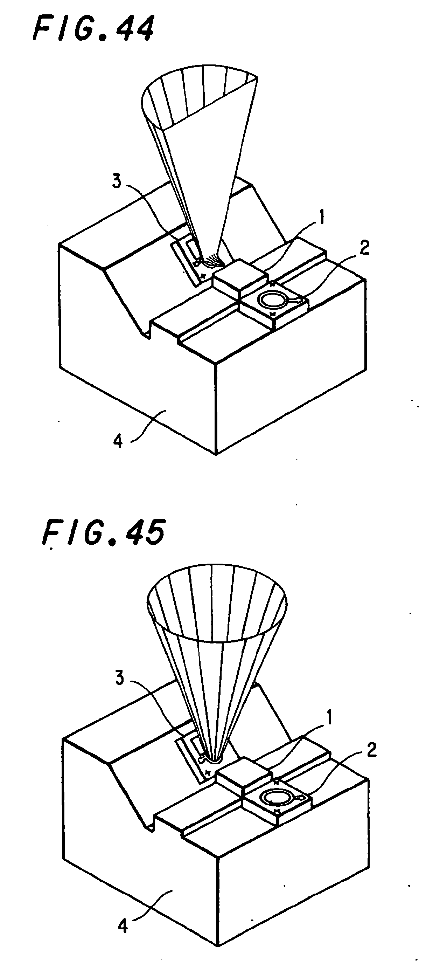

Fig.44 is a diagram showing how the transmitted signal light goes out from the sub-mount;
Fig.45 is a diagram showing how the received signal light impinges on the sub-mount;

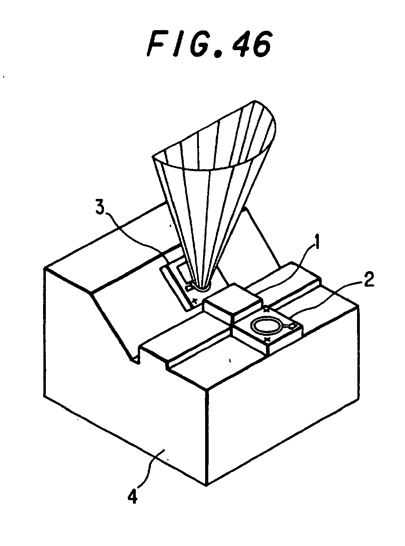

Fig.46 is a view showing, the received signal light, especially, only the light beam that can enter the interior of a photodiode in the sub-mount;
Fig.47 is a block diagram showing a PDS system;

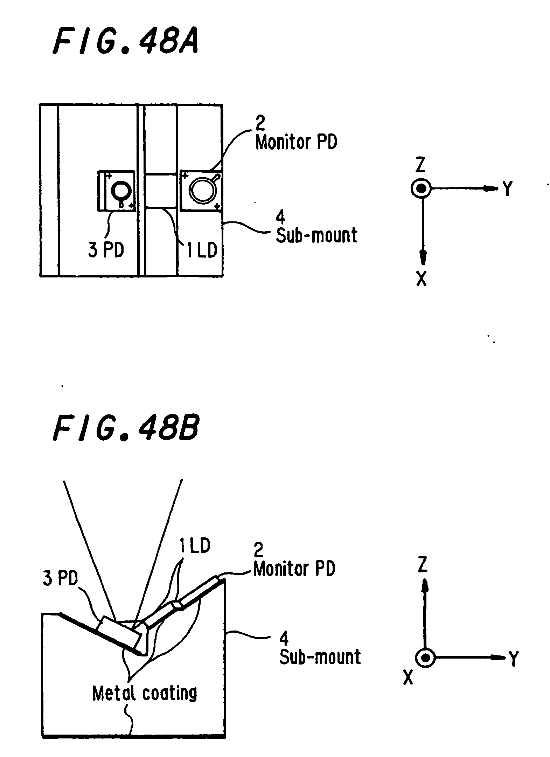

Figs.48A and 48B are diagrams showing the sub-mount of a fourth an optical transmission/reception module , Fig.48A is a top view and Fig.48B is a side view;

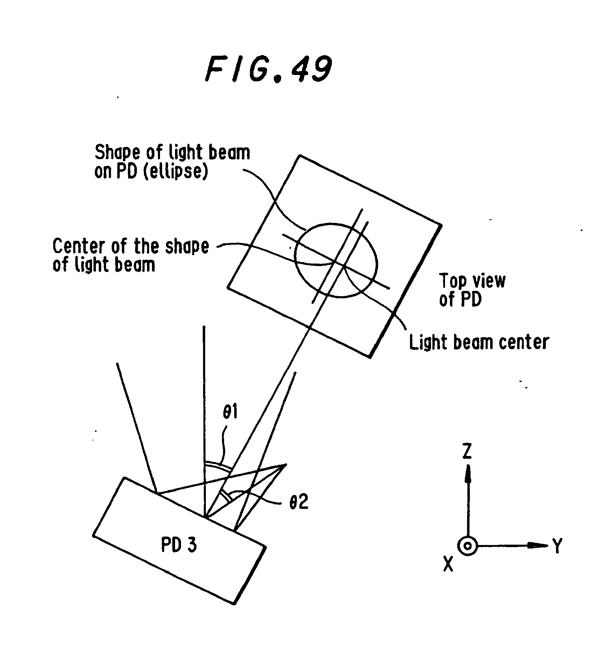

Fig.49 is a diagram showing the shape of the light beam on a photodiode in the fourth module ;

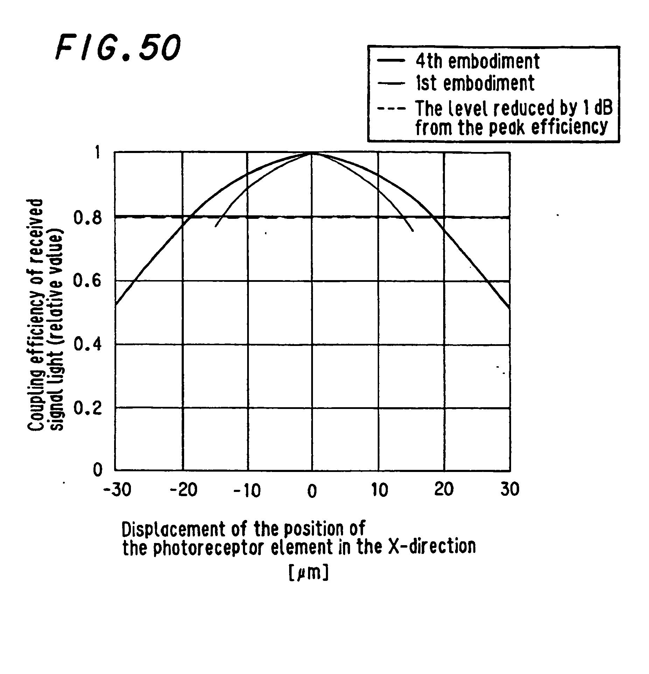

Fig.50 is a chart showing the variations in coupling efficiency of the received light when the position of a photoreceptor element is displaced in the X-direction;

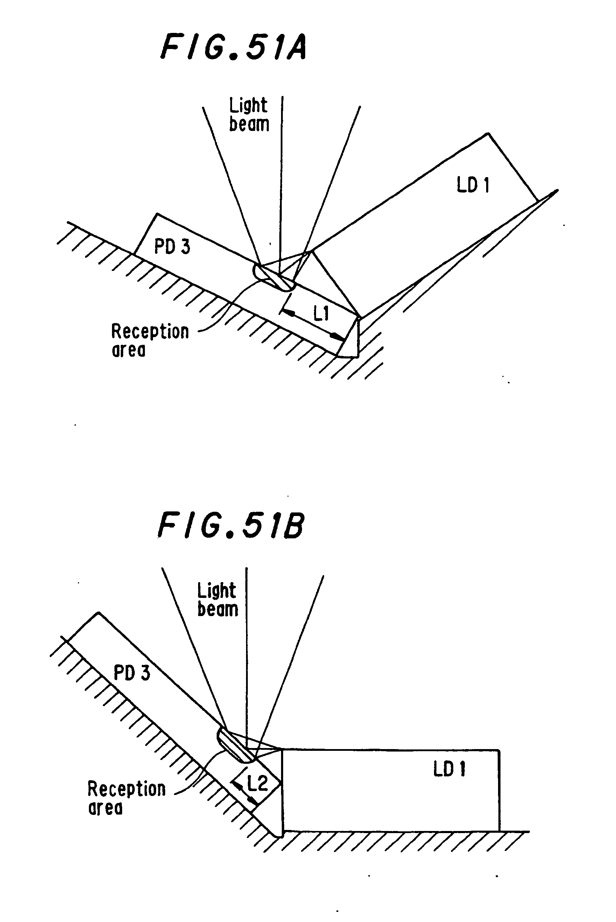

Figs.51A and 51B are diagrams showing the position of a reception area of a photoreceptor element, Fig.51A showing the case of the fourth module and Fig.51B showing the case of the first module;

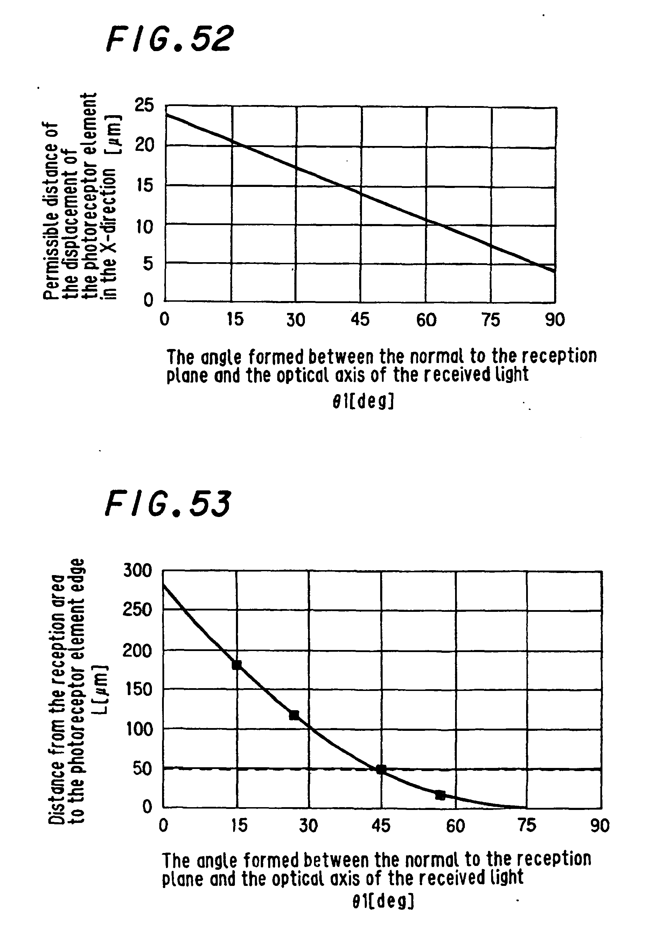

Fig.52 is a graph showing the relationship between angle θ1 formed between the normal to the reception plane of a photodiode of the fourth module and the optical axis of the received light, and the permissible distance of the displacement of the photodiode (photoreceptor element) in the X-direction;
Fig.53 is a graph showing the relationship between angle θ1 formed between the normal to the reception plane of a photodiode of the fourth module and the optical axis of the received light, and the distance L1 from the reception area of the photodiode to the edge of the photodiode; and

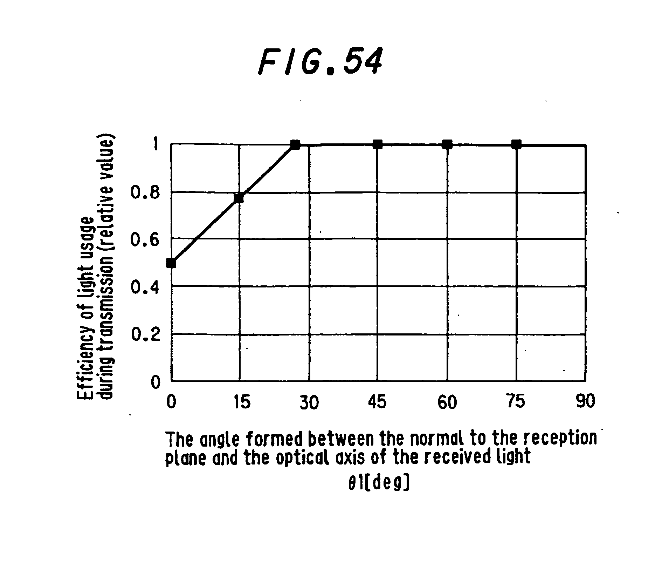

Fig.54 is a graph showing the relationship between angle θ1 formed between the normal to the reception plane of a photodiode of the fourth module and the optical axis of the received light, and the efficiency of light usage during transmission.

### DESCRIPTION OF THE PREFERRED EMBODIMENTS

The embodiment of the invention will hereinafter be described with reference to the accompanying drawings.

### (The first comparative example)

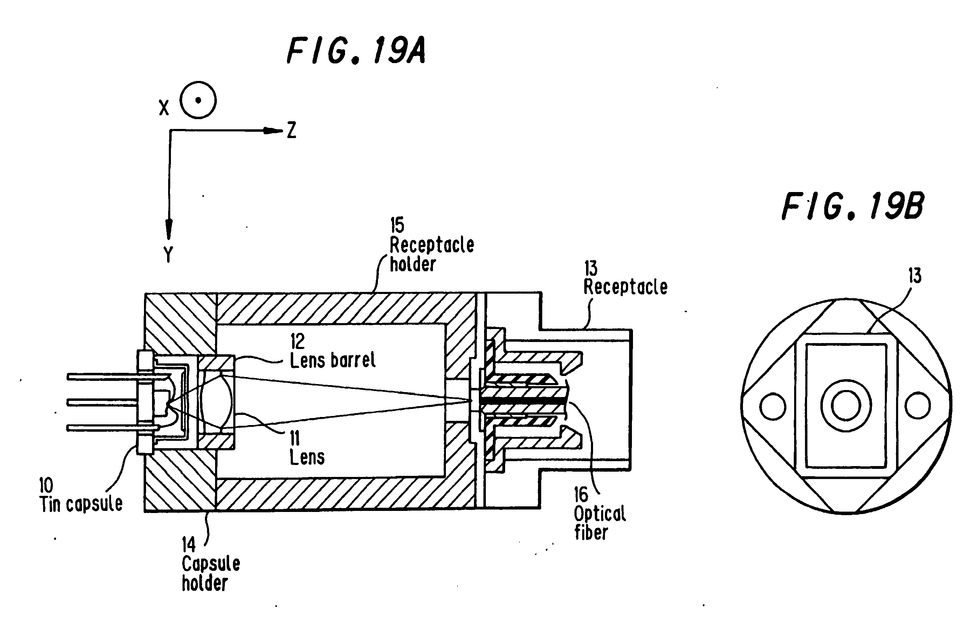

Fig.19A is a sectional view of configuration showing a first optical transmission/reception module , and Fig.19B is a side view thereof. This module comprises a tin capsule 10 in which a laser diode and a photodiode are hermetically sealed, a lens 11, a receptacle 13, a capsule holder 14 and receptacle holder 15 for holding these.

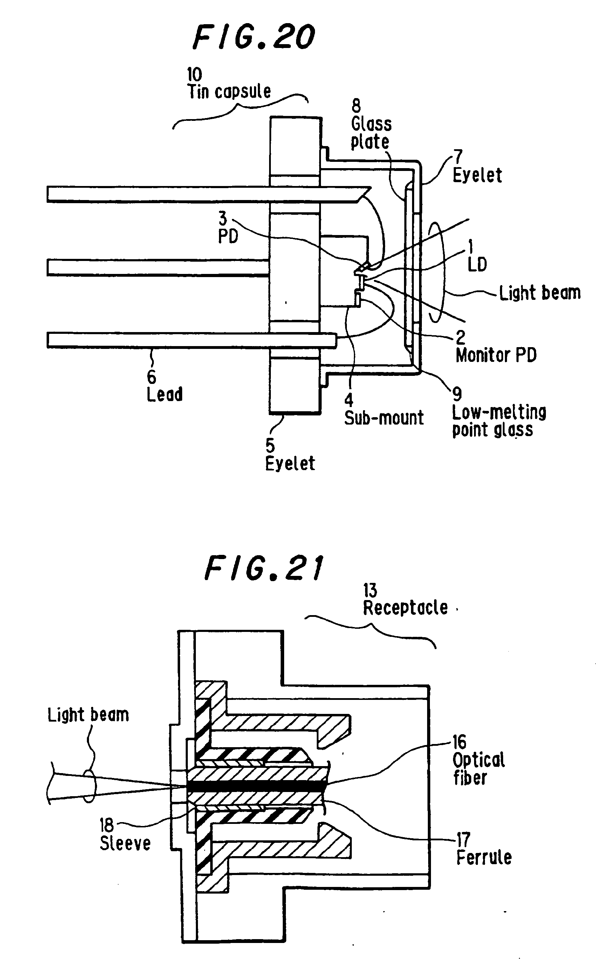

Fig.20 is an enlarged view of tin capsule 10 as a main part of the optical transmission/reception module. Transmission signal light emitted from a laser diode (light emitting element) 1, whilst diverging, impinges on a signal detector photodiode (photoreceptor element) 3 arranged at an angle relative to the optical axis. When the optical branching element formed on photodiode 3 has a branching ratio of 1 : 1 for example, 50 % of the incident signal light is reflected by photodiode 3, impinging on lens 11. The signal light incident on lens 11 converges by the focusing function of lens 11 as shown in Fig.19A so as to enter the single core portion of an optical fiber 16, propagating inside optical fiber 16. The received signal light outgoing from optical fiber 16 proceeds in the reverse direction to the transmission signal light, towards the signal detector photodiode 3. The incident received signal light is then introduced by the optical branching element, and 50 % of it passes into signal detector photodiode 3 where it is converted into the received signal current.

Next, the procedural steps of assembling the optical transmission/reception module will be explained. First, tin capsule 10 is fixed to capsule holder 14 by screw-fitting, welding, using an adhesive or any other fixing method. Receptacle 13 is fixed to receptacle holder 15 by screw-fitting, welding, using an adhesive or any other fixing method. Next, lens 11 is mounted in a lens barrel 12 inside capsule holder 14. With laser diode 1 turned on, lens 11 is slid and adjusted with respect to the optical direction (in the Z-direction in Fig.19A) whilst checking the shape of the focused spot of beam which is focused by lens 11 using an unillustrated camera or the like. When the lens is placed at a position where the size of the focused spot of beam is at its minimum, the lens is fixed by welding, using an adhesive or other methods. Then, with capsule holder 14 put in contact with receptacle holder 15, tin capsule 10 is slid and adjusted with respect to the directions perpendicular to the optical axis direction (Z-direction), i.e., along the X-Y plane in Fig.19A, whilst the light output which impinges on an unillustrated plug (optical fiber) inserted in receptacle 13 is monitored thereby. When the tin capsule is placed at a position where the light output is at its maximum, the capsule holder and receptacle holder are joined by welding, using an adhesive or the like. Thus, the module can be finished.

Next, each of the above components will be described in detail.

Fig.21 shows a section of receptacle 13. As the receptacle 13, a publicly known one can be used as appropriate, for example, one equivalent to the adapter or plug defined as JIS C5973 'FCO4 type single core optical fiber connector'. The function is to hold the end face of optical fiber 16 inside ferrule 17 in the plug, at a designated position.

A structure for an optical transmission/reception module having such a receptacle is called a receptacle type; a structure in which an optical fiber directly comes out from the module (see Fig.4) is called a pigtail type. In this embodiment, a receptacle type is shown, but a pigtail type can also be fabricated. Optical fiber 16 is held inside ferrule 17 which is supported by a sleeve 18 inside receptacle 13.

Lens 11 is an aspheric lens formed by glass-pressing, and is integrally formed with metal barrel 12 when it is pressed. In this example, an aspheric lens is used, but other lenses such as SELFOC lens, spherical lens or combination of them may be used.

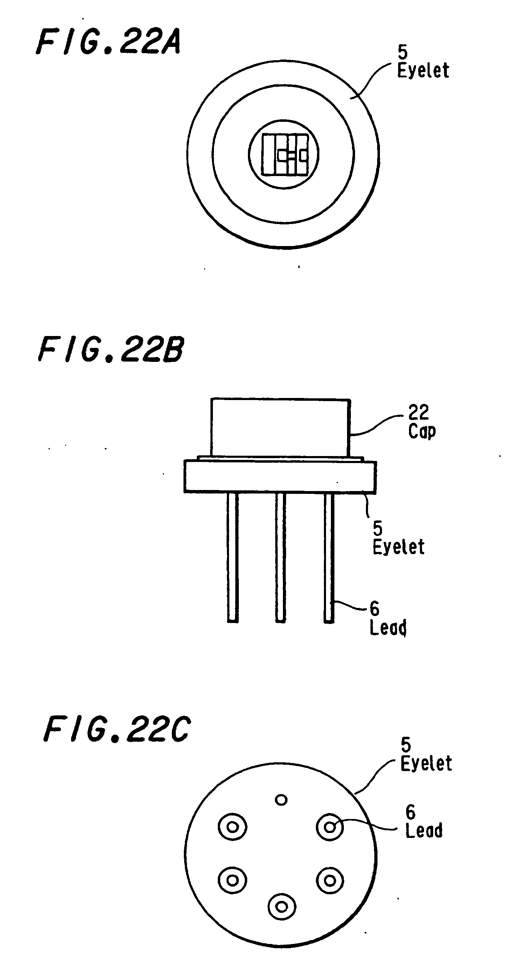

Figs.22A-22C are schematic views of tin capsule 10; Fig.22A is a top view, Fig.22B a side view and Fig.22C a bottom view. Figs.23A-23C are schematic views of tin capsule 10 with a cap 22 removed therefrom; Fig.23A is a top view, Fig.23B a side view and Fig.23C a bottom view. Fig.24 is a sectional view showing cap 22.

As an example of components of tin capsule 10, a stem 21 is composed of an eyelet (base portion) 5 of annealed copper, six leads (electrodes) 6 of Kovar. Of leads 6, five of them (6A, 6B, 6C, 6D and 6E) are electrically insulated from eyelet 5 by glass and fixed thereto so that their end portions project out from the top surface of eyelet 5. The remaining lead (6F) is fixed to eyelet 5 by welding so as to form an electrical connection therebetween. A sub-mount 4 of ceramic is fixed on the top surface of eyelet 5 by brazing. Since brazing cannot be inherently implemented for ceramics, a metal coating (such as gold, titanium, platinum etc., see Fig.26A and 26B) is formed on the contact surface of sub-mount 4 by sputtering or other methods, and then brazing is implemented. The top surface of sub-mount 4 is composed of a plurality of slanted facets, on which signal detector photodiode (photoreceptor element) 3, laser diode (light emitting element) 1 and monitor photodiode (photoreceptor element) 2 are fixed thereon by brazing. Each semiconductor chip is electrically connected to lead 6 by bonding wire 20 (of gold, aluminum wire etc.).

There are three semiconductor chips, each having two electrodes, so that six leads 6 are needed. Because laser diode 1 and monitor photodiode 2 can use a common electrode (for example, common cathode), five leads are adequate. In Fig.23A, laser diode 1 is connected to lead 6C, monitor photodiode 2 to lead 6D, and photodiode 3 to lead 6A, and lead 6B is connected to the remaining electrode of photodiode 3. Lead 6E is connected to a common electrode of laser diode 1 and monitor photodiode 2. In this example, the aforementioned common electrode is formed by the metal coating for brazing formed on sub-mount 4. Lead 6F which is welded to eyelet 5 of this example is electrically shielded, and is used to connect tin capsule 10 to an electrical ground. When an amplifier to be connected to photodiode 3 on its downstream side, is formed of a semiconductor chip and integrated within the same tin capsule 10, it is possible to enhance the resistance to noise. In this case, the number of leads 6 will be varied.

Cap 22 is formed of an eyelet 7 of Kovar and a glass plate 8. This glass plate 8 is fixed to eyelet 7 by low-melting point glass 9.

After the semiconductor chips have been mounted and wire-bonded on stem 21, cap 22 and stem 21 are joined by seam welding in a nitrogen atmosphere to complete the tin capsule 10.

Fig.25 is a perspective view showing sub-mount 4. Fig.26A is a top view showing sub-mount 4, and Fig.26B is a side view thereof. Part of the light emitted from laser diode 1 shown in Fig.26B impinges on monitor photodiode 2 and is converted into a control signal for light output of laser diode 1. The remaining part impinges on photodiode 3 as a transmission signal. A designated proportion of the light is reflected upwards by the optical branching element on photodiode 3, passing through lens 11 to enter optical fiber 16. The received signal light outgoing from optical fiber 16 proceeds in the reverse direction to the transmission signal light, entering photodiode 3. A predetermined proportion of the light is split at the optical branching element to penetrate into photodiode 3, where the light is converted into a received signal current.

Fig.27 shows a top view of photodiode 3. As the communication speed is made higher, the capacitance of the photoreceptor element needs to be reduced, therefore it is necessary to reduce the size of reception area RA. The light incident on an inclined photoreceptor element produces an elliptic spot on the photoreceptor element. Therefore, when the reception area is formed to meet the shape of the light spot, i.e., the elliptic shape, it is possible to receive the light at its maximum efficiency with a minimum size of reception area. Accordingly, the speed of response is enhanced. For this reason, reception area RA of photodiode 3 is set to be elliptic.

Fig.28 is a perspective view showing how the light beam is reflected upwards by the optical branching element on photodiode 3. An enlarged portion A illustrates that when the reception light beam from optical fiber 16 or the transmission light beam from laser diode 1 impinges on photodiode 3 positioned at an angle relative to respective optical axes, the section becomes an ellipse. Accordingly, an elliptic reception area RA2 shown in Fig.30 is smaller in size than a reception area RA1, which is a circle as shown in Fig.29, thus achieving a higher speed of response. In practice, the emitted light from an actual laser diode 1 has an elliptic intensity distribution (for example, the radiating angles (represented by full angle at half the maximum) in the plane of the junction of laser diode 1 and in the plane perpendicular to that of the junction are 27° and 32°, respectively.), but this is not shown because the aperture of lens 11 is a circle and hence the coupled part of the light beam emitted from laser diode 1 with optical fiber 16 has a circular distribution.

Figs.31A and 31B show a structural example of photodiode 3 and are top and sectional views, respectively. This photodiode has the same configuration as the conventional one except that reception area RA is made elliptic. Marks '+' on the top surface of the photodiode designate positioning makers 23 and are used when it is mounted to sub-mount 4.

Figs.32 and 33 are perspective views showing how the transmission signal light is emitted and how the received signal light impinges on sub-mount 4, respectively. For the case of the transmission light, the light emitted from laser diode 1 is reflected upward on the optical branching element on photodiode 3. For the case of the received light, the incident light is split at the optical branching element on photodiode 3, penetrating into the interior of photodiode 3.

Here, Figs.34A and 34B show another example of a sub-mount 4 and are top and side views, respectively. As shown in these figures, by dividing the sub-mount into two sub-mount sections 4a and 4b, the adjustment can be made easier (though the cost for the parts increases).

Figs.35A and 35B show still another example of a sub-mount 4 and are top and side views, respectively. This configuration, on the analogy of the proposal of conventional example 2, is an example in which photodiode 3 is also made to serve as monitor photodiode 2.

Figs.36A and 36B show a further example of a sub-mount 4 and are top and side views, respectively. This configuration is a case where monitor photodiode 2 is positioned perpendicular to the emitted light from laser diode 1 so as to increase the efficiency of light usage.

In the above description of the embodiments, a tin capsule was used for hermetic confinement, a ceramic package or the like may be used. Further, photodiode 3 was placed between laser diode 1 and lens 11, but the photodiode may be placed between lens 11 and receptacle 13 (optical fiber 16).

As described above, since a photoreceptor element having an optical branching element integrally formed on the surface thereof is used, there is no necessity to provide a separate part such as a coupler or the like which functions as the optical branching element. On the other hand, the optical branching element needs to have a high degree of flatness, but the surface of the photoreceptor element inherently has a high degree of flatness because it is produced by a photolithographic process. Therefore, the grinding and polishing step which was needed for producing an optical element such as a coupler, is no longer necessary. Further, conventionally, the surface of the photoreceptor element would be laminated with a dielectric multiple layer coating or single layer coating as an anti-reflection film, therefore it is possible to use the conventional production machines for producing a reflection enhancing film by simply modifying the number of lamination layers and the thickness of the layers.

### (The second comparative example)

Referring next to Fig.37, a second optical transmission/reception module will be explained only describing its difference from the first example.

First, assume that the oscillation wavelength of a laser diode 1 of a module M1 is λ1 and the oscillation wavelength of another laser diode 1 of a module M2 is λ2. A wavelength separating film which reflects light waves having a wavelength of λ1 and transmits light waves having a wavelength of λ2 is formed on the surface of a photodiode 3 of module M1 by a dielectric multi-layer coating. On the other hand, a wavelength separating film which reflects light waves having a wavelength of λ2 and transmits light waves having a wavelength of λ1 is formed on the surface of a photodiode 3 of module M2 by a dielectric multi-layer coating.

Since the transmittance or reflectivity of a dielectric multi-layer coating can be designed to have dependence upon wavelengths, it is possible to use conventional production machines to create a wavelength separating element of a dielectric multi-layer coating on the surface of the photoreceptor element and complete a module which can be applied to wavelength division two-way communications. The thus formed modules are connected by an optical fiber, it is possible to implement the wavelength division two-way communication shown in Fig.14.

### (The first embodiment)

Next, an optical transmission/reception module of an embodiment of the invention will be explained by describing only its difference from the first example.

Fig.38 is a perspective view showing a sub-mount 4 of this embodiment. Fig.39A is a top view of sub-mount 4 and Fig.39B is a side view of sub-mount 4. Fig.40 is a top view of a photodiode 3, of which reception area RA3 is a semi-ellipse. Fig.39B shows light beams emitted from laser diode 1. Part of the light impinges on monitor photodiode 2 and is converted into a control signal for light output of laser diode 1. The remaining part impinges on photodiode 3 as transmission signal light. Part of the light beam is reflected upwards by a reflection film 3a on photodiode 3 and passes through lens 11 shown in Figs.19A and 19B above, entering optical fiber 16. On the other hand, the received signal light outgoing from optical fiber 16 proceeds in the reverse direction to the transmission signal light, entering photodiode 3. Part of the light beam impinges on reception area RA3 of semi-ellipse on photodiode 3, where the incident light is converted into a received signal current.

Fig.41 shows the shape of the light beam on photodiode 3 which impinges as diverging or converging light on photodiode 3 angled with respect to the optical axis. As shown in the top enlarged portion B, the center of the light beam does not coincide with the center of the ellipse.

Fig.42A shows the shape of light beam on photodiode 3 and Fig.42B is a top view of photodiode 3. When the center of the light beam is assumed to divide the ellipse into two areas 1 and 2, as shown in Fig.42A, the energy of light incident on each area is equal to the other. Accordingly, if one of these areas is formed with a reflection film, the incident light can be split at a splitting ratio of 1 : 1. Since the splitting ratio can be varied depending upon the position of dividing the ellipse, it is possible to set the splitting ratio at a ratio other than 1 : 1.

Since the photoreceptor element is slanted relative to the optical axis, the divided area (semi-ellipse) of the light beam on the photoreceptor element, residing on the side where the light arrives later when a converging light beam impinges thereon, is smaller than the other divided area. Conversely, when a diverging light beam impinges on the photoreceptor element, the area (semi-ellipse) residing on the side where the light arrives earlier is smaller than the other area. Since either side receives an equal amount of light energy, provision of a reception area on the smaller side in the photoreceptor element is of great advantage to make the speed of response faster.

In this embodiment, as shown in Fig.42B, area 2 is smaller than area 1, so that it is preferable to assign area 2 to the reception area of photodiode 3, to achieve a higher speed of response. In this case, when the photoreceptor receives a converging light beam (this corresponds to the placement of photodiode 3 between laser diode 1 and lens 11 in Figs.19A, 19B and 20), area 2 is on the side where the converging light arrives later; when it receives a diverging light beam (this corresponds to the placement of photodiode 3 between lens 11 and laser receptacle 13 in Figs.19A, 19B and 20), area 2 is on the side where the diverging light arrives earlier. In this embodiment, since the reception area of photodiode 3 can be made smaller than that in the first embodiment, it is possible to achieve a higher speed of response.

Figs.43A and 43B show a structural example of a photodiode 3, and top and sectional views, respectively. This photodiode has the same structure as the conventional one except an optical branching element (a reflection film) is formed on the surface thereof. A reflection film 3a is a metal coating (aluminum, gold, etc.) formed on the anti-reflection coating of electrical insulator or a reflection intensifier film which is formed of a dielectric multi-layer coating (of a single layer film of Si₃N₄ etc., or of a dielectric multi-layer coating). When this is formed of a metal coating and if it is electrically connected to the electrode, the surface area becomes large so that the capacitance increases and hence the speed of response becomes low. To avoid this, an electrical insulation 3b is needed against the electrode as shown in Fig.43A and 43B. This insulation can be formed by providing a gap or an insulator.

Figs.44 and 45 show how the transmission signal light from laser diode 1 impinges on and how the received signal light impinges on sub-mount 4, respectively. Fig.46 is a view showing, the received signal light, especially, only the bundle of rays that can enter the interior of photodiode 3.

As described above, a reflection film for reflecting part of the light beam is formed on the surface of the photoreceptor element so that part of the light that impinges on the photoreceptor element is reflected and the remaining part of it is allowed to pass into the interior of the photoreceptor element. As a result, it is possible to provide the function of an optical brancher. Further, conventionally, the surface of the photoreceptor element would be formed with an electrode of a metal coating (aluminum etc.), therefore it is possible to use the conventional production machines so as to easily produce a metal coating (aluminum etc.) because the anti-reflection film is of an insulator.

### (The fourth example (comparative example))

A fourth optical transmission/reception module will be explained by describing only its difference from the first example. Figs.48A and 48B are top and side views of a sub-mount 4. Part of the light beam of the light emitted from a laser diode 1 shown in Fig.48 impinges on a monitor photodiode 2 and is converted into a control signal for light output of laser diode (light emitting element) 1. The remaining part impinges on photodiode (photoreceptor element) 3 as transmission signal light and a designated proportion of the light is reflected upwards by the optical branching element on photodiode 3. The difference from the first example is that the angle formed between the normal to the reception plane of the photodiode and the optical axis of the received light (the angle corresponding to θ1 in Fig.49) was 45° in the first embodiment, but this is set at a value equal to or less than 45° in this fourth example.

Fig.49 is an illustration for explaining the shape of light beam on photodiode 3 when transmission light or received light impinges on photodiode 3. In this figure, θ1 represents the angle between the normal to the reception plane of photodiode 3 and the optical axis of the received light, and θ2 represents the angle between the optical axis of the emitted light from laser diode 1 and the normal to the reception plane of photodiode 3.

In Fig.49, the center of the light beam does not coincide with the center of the ellipse, as in the first example. Since the incident angles (θ1 and θ2) of the light on photodiode 3 are both as small as 27°, the distribution of the light beam is closer to a circle than that in the first example.

In the fourth example, the angle between the normal to the reception plane and the optical axis of the received light is 45° or below, and typically, 27° is particularly preferred and set in Figs.48A and 48B. When photodiode 3 is set up so that the angle θ1 = 27°, it is preferable to set the angle between the optical axis of the light emitted from laser diode 1 and the normal to the reception plane of photodiode 3 (corresponding to θ2 in Fig.49) to be 27° in order to efficiently couple the transmission light with the optical fiber. The value θ1 = 27° as the preferred example of this value is selected because it is the optimal value based on the condition that the transmission light, which is reflected on the half transmission coating on the surface of the photodiode during transmission and then is picked up by the lens, will not be shaded by the laser diode itself while still making the angle as small as possible. When a stem which has a top surface (the mounting surface on the sub-mount) perpendicular to the optical axis of the received light is used, photodiode 3 and laser diode 1 will be angled 27° and 36°, respectively relative to the top surface of the stem.

Fig.50 is a chart showing the variations in coupling efficiency of the received light when the position of photodiode 3 is displaced in the X-direction. In the graph, the thin solid curve represents the values of the coupling efficiency in the case of the first example and the thick solid curve represents the values of the coupling efficiency in the case of the fourth example. The dashed line designates the level when the value of the coupling efficiency decreases by 1 dB. Now, from the comparison based on the graph, the permissible distance of the displacement of photodiode 3 from the optimal position, i.e., the range within which the coupling efficiency from the peak reduces by 1 dB is ±14 µm in the first example, whereas the distance is ±18 µm in the fourth example. Thus, the permissible range concerning the displacement of photodiode 3 in the X-direction is improved or broadened.

**Table 1**

| Displacement of the photodiode within which the optical coupling efficiency from the peak reduces by 1 dB during the periods of reception | | |
|---|---|---|
| | The 4th example | The 1st example |
| X-axis | ±18 µm | ±14 µm |
| Y-axis | -15 µm to +24 µm | -10 µm to +25 µm |
| Z-axis | -157 µm to +26 µm | -109 µm to +20 µm |

Table 1 shows permissible ranges with respect to the X-axis, Y-axis and Z-axis within which the coupling efficiency reduces by 1 dB from the peak in the cases of the first and fourth embodiments. For all the axes, the fourth example outstrips the first example. Here, since the capacitance of photodiode 3 will decrease and hence the speed of response will increase as the reception area of photodiode 3 becomes smaller, the comparisons in both Fig.50 and Table 1 are made under the same condition as to reception area.

Fig.51A is a diagram showing the position of the reception area of photodiode 3 in accordance with the fourth example. Fig.51B is a diagram showing the position of the reception area of photodiode 3 in accordance with the first example. Since it is necessary to make the reception area smaller from the stand point of the speed of response, photodiode 3 must be placed within a certain distance from laser diode 1, in both cases shown in Figs.51A and 51B. Further, to avoid an electrical short-circuit, it is necessary to provide a small gap between photodiode 3 and laser diode 1. For the above reasons, the distance between the reception area of photodiode 3 and the edge of photoreceptor 3 (the distances L1 and L2) is limited to within a certain distance. Although laser diode 1 and photodiode 3 are illustrated in contact with each other in Figs.51A and 51B, the actual distance will be slightly shorter than L1 and L2.

Fabrication of the photodiodes is performed by forming a number of the elements as a whole on a wafer and separating them into individual chips. If the reception area is provided near the edge of the photodiode, stress which will be generated in the reception area when the wafer is cut into chips tends to cause characteristic degradation such as increase in dark current of the photodiode or other defects. Therefore, the reception area is preferably formed away from the photodiode edge.

In the case where the two reception areas are equal as shown in Figs.51A and 51B, the fourth example is advantageous over the first example in that the distance between the reception area and the photodiode edge can be set greater in the former than the latter (L1 > L2). For example, during 50 Mbps optical fiber communication, the reception area is preferably smaller than the area of a circle of 75 µm in diameter. Under this condition, L2 must be smaller than 47 µm in the first example, but in the fourth example, L1 can be set within a wider range, i.e., smaller than 117 µm.

Fig.52 is a graph showing a plot for the fourth example in which the angle θ1 (degrees) formed between the normal to the reception plane of photodiode 3 and the optical axis of the received light is taken along the axis of the abscissa and the permissible distance (µm) of the displacement of the photodiode (photoreceptor element) in the X-direction is taken along the axis of the ordinate. For θ1 = 0°, 15°, 27°, 30°, 45°, 60° and 75°, the permissible distance (µm) in the X-direction is found to be 24.0 µm, 20.7 µm, 18.0 µm, 17.3 µm, 14.0 µm, 10.7 µm and 7.4 µm. As the angle formed between the normal to the reception plane and the optical axis of the received light is smaller, the permissible distance of the displacement of the photodiode becomes large, which means that fabrication becomes easier.

Fig.53 is a graph showing a plot for the fourth example in which the angle θ1 (degrees) formed between the normal to the reception plane of photodiode 3 and the optical axis of the received light is taken along the axis of the abscissa and the distance L1 (µm) from the reception area of the photodiode to the photodiode edge is taken along the axis of the ordinate. For θ1 = 0°, 15°, 27°, 30°, 45°, 57°, 60° and 70°, the distance L1 is found to be 283.3 µm, 181.8 µm, 117.0 µm, 103.1 µm, 50.0 µm, 18.5 µm, 13.6 µm and 4.0 µm. The dashed line along the level at L1 (µm) = 50 µm, shows a threshold level above which no characteristic deterioration such as increase in dark current of the photodiode due to stress deformation generated in the reception area during chip separation will occur. To meet the requirement L1 ≥ 50 µm, θ1 (degrees) should be equal to 45° or below.

Fig.54 is a graph showing a plot for the fourth example in which the angle θ1 (degrees) formed between the normal to the reception plane of photodiode 3 and the optical axis of the received light is taken along the axis of the abscissa and the efficiency of light usage (relative value) during transmission is taken along the axis of the ordinate. For θ1 = 0°, 15°, 27°, and 30° - 75°, the efficiency of light usage (relative value) is found to be 0.5, 0.78, 1.0 and 1.0-1.0. In Fig.54, if, for example, the necessary efficiency of light usage (relative value) is assumed to be equal to or greater than 0.78, θ1 should be equal to 15° or greater, and is more preferably equal to or greater than 27°. If θ1 is smaller than 27°, the transmission light which is reflected on the half transmission coating on the photodiode surface will be shaded by the laser diode, and therefore the efficiency of light usage during transmission lowers.

From the above data shown in Figs.52, 53 and 54, the angle θ1 formed between the normal to the reception plane of photodiode 3 and the optical axis of the received light needs to be set between 15° and 45° (15° ≤ θ1 ≤ 45°).

### (The fifth example (comparative example)),

A fifth optical transmission/reception module will be explained by describing only its difference from the first to fourth modules. For the description, Figs.23A to 23C above are used. In these figures, the front end face of lead 6A of the stem should be approximately parallel to the surface of PD3, the front end face of lead 6C is approximately parallel to the surface of LD1, and front end face of lead 6E is approximately parallel to the horizontal top surface of sub-mount 4. In the wire-bonding step, since it is impossible to connect bonding wire to a target which is steeply inclined to a normal wire bonder head (not shown), it is necessary to rotate the stem so as to align the target approximately parallel to the wire bonder head and then perform bonding.

In the fifth example, since each lead and element corresponding thereto are arranged approximately parallel to each other, this configuration is advantageous in that only a single rotation of the stem can achieve adjustment for connecting one piece of bonding wire (bonding twice for both ends). Further, the stem does not need to be rotated for adjustment whilst only one end of the bonding wire is being connected and hence the risk that unwanted stress which will be exerted on the bonding wire becomes lower. In this way, the wire, beneficially, will not disconnect or break.

In accordance with the invention, the optical transmission/reception module uses a photoreceptor element having an optical branching element integrally formed on the surface thereof, without the necessity to provide a separate optical branching element, so that the module can be easily assembled and reduced in size and cost.

In the optical transmission/reception module in accordance with the invention, a reflection film for reflecting part of the light beam is formed on the surface of the photoreceptor element, and the reception area in the photoreceptor element is formed in such a shape which can receive the other part of the light beam. As a result, part of the light that impinges on the photoreceptor element is reflected and the remaining part of the light passes into the interior of the photoreceptor element, thus providing the function of optical branching. Further, since this reflection film can be produced by a conventional fabrication installation for photoreceptor elements, no investment for additional installation is needed.

Since the optical transmission/reception module in accordance with the invention has a semi-elliptic reception area in the photoreceptor element, it is possible to make the reception area smaller than conventional circular or elliptic areas and hence reduce the capacitance of the photoreceptor element, thus improving the speed of response.

In the optical transmission/reception module in accordance with the invention, the reception area in the photoreceptor element is formed on the side where the light arrives later when a converging light beam impinges thereon, while it is provided on the side where the light arrives earlier when a diverging light beam impinges thereon. This configuration enables reduction in size of reception area, and hence reduces the capacitance of the photoreceptor element, thus improving the speed of response.

In accordance with the optical transmission/reception module of the invention, the front end face of the leads of the stem is formed approximately parallel to the surface of the corresponding element surface to which bonding wire is bonded, therefore, only one rotation of the stem can advantageously achieve adjustment for connecting each piece of bonding wire. Further, the stem does not need to be rotated for adjustment whilst only one end of the bonding wire is being connected and hence the risk that unwanted stress which will be exerted on the bonding wire becomes lower. In this way, the wire, beneficially, will not disconnect or break.

## Claims

1. An optical transmission/reception module for use in performing two-way communication by way of an optical fibre (16), the module comprising:
a light-emitting element (1) for emitting signal light; and
a photoreceptor element (3) which is disposed inclined with respect to the optical axis of signal light from the optical fibre (16) and has an optical branching element formed on a surface thereof, the surface, in use, partially reflecting signal light from the light emitting element (1) and signal light from the optical fibre (16) and allowing the remaining part of the signal light to pass therethrough; wherein, in use, the signal light from the light-emitting element (1) is reflected on the optical branching element on the surface of the photoreceptor element and is optically coupled with the optical fibre (16); and wherein, in use, signal light from the optical fibre (16) passes through the optical branching element and enters the photoreceptor element;
**characterised in that** the optical branching element comprises a reflection film (3a) disposed over a part of the surface of the photoreceptor element (3), the reflection film (3a), in use, reflecting part of a light beam incident on the surface of the photoreceptor element (3); **in that** a part of the surface of the photoreceptor element over which the reflection film (3a) is not disposed defines a reception area (RA3) of the photoreceptor element (3), the reception area (RA3) of the photoreceptor element having a shape which can receive the remaining part of the incident light beam; and **in that** the reception area (RA3) of the photoreceptor element (3) is formed on a side of the surface of the photoreceptor element (3) where light arrives later, compared to the arrival of light at another side of the surface, when a converging light beam from the optical fibre (16) is incident on the surface and where light arrives earlier, compared to the arrival of light at another side of the surface, when a diverging light beam from the light-emitting element (1) is incident on the surface.

2. An optical transmission/reception module as claimed in claim 1 wherein the reception area (RA3) of the photoreceptor element has a semi-elliptic shape.

3. An optical transmission/reception module as claimed in claim 1 or 2 wherein an end of each lead (6A...6E) of a stem (21) having the light-emitting element (1) and the photoreceptor element (3) mounted thereon is formed approximately parallel to the surface of the corresponding element to which the lead (6A...6E) is to be joined by a bonding wire (20).

## Patentansprüche

1. Optisches Sende-/Empfangsmodul für die Verwendung bei der Ausführung einer Zweiwegekommunikation mittels einer Lichtleitfaser (16), wobei das Modul versehen ist mit:
einem lichtemittierenden Element (1), um Signallicht zu emittieren; und
einem Photorezeptorelement (3), das geneigt in Bezug auf die optische Achse von Signallicht von der Lichtleitfaser (16) angeordnet ist und ein optisches Verzweigungselement besitzt, das an einer Oberfläche hiervon ausgebildet ist, wobei die Oberfläche im Gebrauch Signallicht von dem lichtemittierenden Element (1) und Signallicht von der Lichtleitfaser (16) teilweise reflektiert und den verbleibenden Teil des Signallichts durchlässt; wobei im Gebrauch das Signallicht von dem lichtemittierenden Element (1) an dem optischen Verzweigungselement auf der Oberfläche des Photorezeptorelements reflektiert wird und mit der Lichtleitfaser (16) optisch gekoppelt wird; und wobei sich im Gebrauch Signallicht von der Lichtleitfaser (16) durch das optische Verzweigungselement bewegt und in das Photorezeptorelement eintritt;
**dadurch gekennzeichnet, dass** das optische Verzweigungselement eine dünne Reflexionsschicht (3a) enthält, die über einem Teil der Oberfläche des Photorezeptorelements (3) angeordnet ist, wobei die dünne Reflexionsschicht (3a) im Gebrauch einen Teil eines Lichtstrahlenbündels, das auf die Oberfläche des Photorezeptorelements (3) auftrifft, reflektiert; dass ein Teil der Oberfläche des Photorezeptorelements, über dem die dünnen Reflexionsschicht (3a) nicht angeordnet ist, einen Empfangsbereich (RA3) des Photorezeptorelements (3) definiert, wobei der Empfangsbereich (RA3) des Photorezeptorelements eine Form hat, die den verbleibenden Teil des auftreffenden Lichtstrahlenbündels empfangen kann; und dass der Empfangsbereich (RA3) des Photorezeptorelements (3) auf einer Seite der Oberfläche des Photorezeptorelements (3) ausgebildet ist, auf der Licht im Vergleich zu der Ankunft von Licht auf einer weiteren Seite der Oberfläche später ankommt, wenn ein konvergierendes Lichtstrahlenbündel von der Lichtleitfaser (16) auf die Oberfläche auftrifft, und auf der Licht im Vergleich zu der Ankunft von Licht auf einer weiteren Seite der Oberfläche früher ankommt, wenn ein divergierendes Lichtstrahlenbündel von dem lichtemittierenden Element (1) auf die Oberfläche auftrifft.

2. Optisches Sende-/Empfangsmodul nach Anspruch 1, wobei der Empfangsbereich (RA3) des Photorezeptorelements eine halbelliptische Form hat.

3. Optisches Sende-/Empfangsmodul nach Anspruch 1 oder 2, wobei ein Ende jeder Leitung (6A, ..., 6E) eines Schafts (21), an dem das lichtemittierende Element (1) und das Photorezeptorelement (3) montiert sind, angenähert parallel zu der Oberfläche des entsprechenden Elements, mit dem die Leitung (6A, ..., 6E) durch einen Bonddraht (20) verbunden werden soll, ausgebildet ist.

## Revendications

1. Module de transmission/réception optique destiné à être utilisé pour une communication bidirectionnelle à l'aide d'une fibre optique (16), le module comprenant :
un élément émetteur de lumière (1) servant à émettre une lumière de signal ; et
un élément photorécepteur (3) qui est disposé de façon inclinée par rapport à l'axe optique de la lumière de signal provenant de la fibre optique (16) et sur une surface duquel est formé un élément de séparation optique, la surface, en service, réfléchissant partiellement la lumière de signal en provenance de l'élément émetteur de lumière (1) et la lumière de signal en provenance de la fibre optique (16) et permettant à la partie restante de la lumière de signal de la traverser ; dans lequel, en service, la lumière de signal en provenance de l'élément émetteur de lumière (1) est réfléchie sur l'élément de séparation optique formé sur la surface de l'élément photorécepteur et est couplée optiquement à la fibre optique (16) ; et dans lequel, en service, la lumière de signal en provenance de la fibre optique (16) traverse l'élément de séparation optique et pénètre dans l'élément photorécepteur ;
**caractérisé en ce que** l'élément de séparation optique comprend un film réfléchissant (3a) disposé sur une partie de la surface de l'élément photorécepteur (3), le film réfléchissant (3a), en service, réfléchissant une partie d'un faisceau de lumière incident sur la surface de l'élément photorécepteur (3) ; **en ce qu'**une partie de la surface de l'élément photorécepteur sur laquelle n'est pas disposé le film réfléchissant (3a) définit une zone de réception (RA3) de l'élément photorécepteur (3), la zone de réception (RA3) de l'élément photorécepteur ayant une forme lui permettant de recevoir la partie restante du faisceau de lumière incident ; et **en ce que** la zone de réception (RA3) de l'élément photorécepteur (3) est formée sur un côté de la surface de l'élément photorécepteur (3) où la lumière arrive ultérieurement, par comparaison avec l'arrivée de lumière au niveau d'un autre côté de la surface, lorsqu'un faisceau de lumière convergent en provenance de la fibre optique (16) est incident sur la surface et où la lumière arrive antérieurement, par comparaison avec l'arrivée de lumière au niveau d'un autre côté de la surface, lorsqu'un faisceau de lumière divergent en provenance de l'élément émetteur de lumière (1) est incident sur la surface.

2. Module de transmission/réception optique selon la revendication 1, dans lequel la zone de réception (RA3) de l'élément photorécepteur a une forme semi-elliptique.

3. Module de transmission/réception optique selon la revendication 1 ou la revendication 2, dans lequel une extrémité de chaque conducteur (6A,...,6E) d'une tige (21) sur laquelle sont montés l'élément émetteur de lumière (1) et l'élément photorécepteur (3) est formée de façon approximativement parallèle à la surface de l'élément correspondant auquel le conducteur (6A,...,6E) doit être uni par un fil de liaison (20).
